# EUROPEAN PATENT APPLICATION

(11) **EP 4 815 684 A1**
(43) Date of publication of application: **30.09.2026**
(21) Application number: 24894741.8
(22) Date of filing: 30.10.2024
(51) Int. Cl.: H10H 20/857, H10H 20/831, H10H 20/84, H10H 20/81, H10H 20/85, H10H 20/856, H10H 20/00, H01L 25/075

(54) **LIGHT-EMITTING DEVICE, DISPLAY DEVICE COMPRISING SAME, AND METHOD FOR MANUFACTURING DISPLAY DEVICE**

(30) Priority: 23.11.2023 KR 20230164677
(71) Applicant: Samsung Display Co., Ltd., Yongin-si, Gyeonggi-do 17113 (KR)
(72) Inventor: KIM, Seul Ki, Yongin-si, Gyeonggi-do 17113 (KR); JIN, Dal Rae, Yongin-si, Gyeonggi-do 17113 (KR); CHA, Hyung Rae, Yongin-si, Gyeonggi-do 17113 (KR)
(74) Representative: Marks & Clerk LLP
(86) International application number: PCT/KR2024/096422
(87) International publication number: WO 2025/110851

(57) **Abstract**

A light-emitting device according to an embodiment includes: a first semiconductor layer; a second semiconductor layer disposed on the first semiconductor layer; a light-emitting layer disposed on the second semiconductor layer; a third semiconductor layer disposed on the light-emitting layer; a device electrode layer disposed on the third semiconductor layer; a connection electrode disposed on the device electrode layer; a first insulating layer surrounding the lateral sides of the first semiconductor layer and the second semiconductor layer; a contact electrode surrounding the lateral sides of the first semiconductor layer and the second semiconductor layer; and a second insulating layer surrounding the lateral sides of the second semiconductor layer, the light-emitting layer, the third semiconductor layer, the device electrode layer, and the connection electrode, wherein the contact electrode is in contact with the lateral sides of the second semiconductor layer.

## Description

### [TECHNICAL FIELD]

The present disclosure relates to a light emitting element, a display device including the same, and a method of manufacturing the display device.

### [BACKGROUND ART]

Display devices are becoming increasingly important with the development of multimedia. In response to this, various types of display devices, such as organic light emitting displays (OLED) and liquid crystal displays (LCD), are being used.

A device for displaying an image of a display device includes a display panel such as an organic light emitting display panel or a liquid crystal display panel. Among them, the light emitting display panel may include a light emitting element. For example, light emitting diodes (LED) include organic light emitting diodes (OLED) that utilize organic materials as light emitting materials, inorganic light emitting diodes that utilize inorganic materials as light emitting materials, and the like.

### [DISCLOSURE]

### [TECHNICAL PROBLEM]

Aspects of the present disclosure provide a light emitting element capable of contacting a side surface of a first semiconductor layer, a display device including the same, and a method of the display device.

However, aspects of the present disclosure are not restricted to those set forth herein. The above and other aspects of the present disclosure will become more apparent to one of ordinary skill in the art to which the present disclosure pertains by referencing the detailed description of the present disclosure given below.

### [TECHNICAL SOLUTION]

According to an aspect of the present disclosure, a light emitting element comprises a first semiconductor layer, a second semiconductor layer disposed on the first semiconductor layer, a light emitting layer disposed on the second semiconductor layer, a third semiconductor layer disposed on the light emitting layer, an element electrode layer disposed on the third semiconductor layer, a connection electrode disposed on the element electrode layer, a first insulating layer surrounding the side surfaces of the first semiconductor layer and the second semiconductor layer, a contact electrode surrounding the side surfaces of the first insulating layer and the second semiconductor layer, and a second insulating layer surrounding the side surfaces of the second semiconductor layer, the light emitting layer, the third semiconductor layer, the element electrode layer, and the connection electrode, wherein the contact electrode is in contact with the side surface of the second semiconductor layer.

The first insulating layer may surround the entire side surface of the first semiconductor layer and a portion of the side surface of the second semiconductor layer.

The contact electrode may not be in contact with the first semiconductor layer.

The second insulating layer may surround the side surface of the contact electrode but may not be in contact with the first insulating layer.

The light emitting element may further comprise a contact area in which the contact electrode and the second semiconductor layer are in contact with each other, wherein the contact area is disposed in an area ranging from 1 to 90% of the length of the second semiconductor layer from the interface between the first semiconductor layer and the second semiconductor layer.

The contact area may range from 1 to 90% of the total area of the side surface of the second semiconductor layer.

The side surface of the first insulating layer, the side surface of the contact electrode, and the side surface of the second insulating layer may be aligned with each other.

The first insulating layer may not be in contact with the second semiconductor layer.

The second insulating layer may not be in contact with the side surface of the contact electrode and may be aligned with the side surface of the contact electrode.

The light emitting element may further comprise a reflective layer surrounding the side surface of the second insulating layer, wherein the side surface of the reflective layer is aligned with the side surface of the contact electrode.

The first semiconductor layer may include undoped semiconductor, the second semiconductor layer may include an n-type semiconductor, and the third semiconductor layer may include a p-type semiconductor.

According to an aspect of the present disclosure, a display device comprises a substrate, a pixel electrode disposed on the substrate, light emitting elements disposed on the pixel electrode, a first organic layer disposed on the pixel electrode and disposed between the light emitting elements, and a common electrode disposed on the first organic layer and the light emitting elements, wherein each of the light emitting elements comprises a connection electrode disposed on the pixel electrode, an element electrode layer disposed on the connection electrode, a third semiconductor layer disposed on the element electrode layer, a light emitting layer disposed on the third semiconductor layer, a second semiconductor layer disposed on the light emitting layer, a first semiconductor layer disposed on the second semiconductor layer, a first insulating layer surrounding the side surfaces of the first semiconductor layer and the second semiconductor layer, a contact electrode surrounding the side surfaces of the first insulating layer and the second semiconductor layer, and a second insulating layer surrounding the side surfaces of the second semiconductor layer, the light emitting layer, the third semiconductor layer, the element electrode layer, and the connection electrode, wherein the contact electrode is disposed on the side surface of the second semiconductor layer and the common electrode is connected to the contact electrode.

The connection electrode may be connected to the pixel electrode and the second semiconductor layer may be electrically connected to the common electrode through the connection electrode.

The top surface of the first organic layer may be aligned with the top surface of the first insulating layer and the top surface of the contact electrode.

The common electrode may be disposed on the first semiconductor layer, the first insulating layer, the contact electrode, and the first organic layer.

The display device may further comprise a third insulating layer disposed between the first semiconductor layer and the common electrode, and the common electrode may not be in contact with the first semiconductor layer.

The third insulating layer may be in contact with the first semiconductor layer and may not be in contact with the first insulating layer.

The common electrode may be in contact with the side surface of the first insulating layer and the side surface of the contact electrode.

The light emitting element further may comprise a reflective layer surrounding the side surface of the second insulating layer, and the first organic layer may cover the reflective layer.

The display device may further comprise a second organic layer disposed on the first organic layer, wherein the common electrode may be disposed between the first organic layer and the second organic layer.

The common electrode may surround and may be in contact with the side surface of the contact electrode, and the second organic layer covers a portion of the common electrode.

According to an aspect of the present disclosure, a method of manufacturing a display device comprises forming a pixel electrode on a substrate, forming light emitting elements on a base substrate, combining the light emitting elements formed on the base substrate on the pixel electrode, forming an organic layer between the light emitting elements on the pixel electrode, and forming a common electrode on the organic layer and the light emitting elements, wherein the forming the light emitting elements on the base substrate comprises, forming a first semiconductor layer, a second semiconductor layer, a light emitting layer, a third semiconductor layer, and an element electrode layer on the base substrate, forming a first insulating layer surrounding the side surfaces of the first semiconductor layer and the second semiconductor layer, forming a contact electrode surrounding the side surfaces of the first insulating layer and the second semiconductor layer, forming a second insulating layer surrounding the side surfaces of the second semiconductor layer, the light emitting layer, the third semiconductor layer, and the element electrode layer, and forming a connection electrode on the element electrode layer.

The first insulating layer, the second insulating layer, and the contact electrode may be formed by simultaneously etching a first insulating material layer, a contact electrode material layer, and a second insulating material layer.

The combining the light emitting elements formed on the base substrate on the pixel electrode may comprise bonding a support film on connection electrodes of the light emitting elements, separating the base substrate from the light emitting elements, bonding a transfer film on one surface of the light emitting elements facing the support film, separating the support film from the light emitting elements, combining the connection electrodes of the light emitting elements on the pixel electrode, and removing the transfer film from the light emitting elements.

After the separating the support film from the light emitting elements, the transfer film may be stretched to increase the interval between the light emitting elements.

In the combining the connection electrodes of the light emitting elements on the pixel electrode, a laser may be irradiated on to the pixel electrode to melt bond the connection electrode to the pixel electrode.

Other features and embodiments may be apparent from the following detailed description and the drawings.

### [ADVANTAGEOUS EFFECTS]

In a light emitting element, a display device including the same, and a method of manufacturing the display device according to an embodiment of the present disclosure, a contact electrode contacting a side surface of a second semiconductor layer may be formed to drive light emitting elements through a common electrode, thereby omitting a removing process of a first semiconductor layer. Accordingly, process errors that can occur during the removing process of the first semiconductor layer can be prevented and productivity of manufacturing process of a display device can be improved.

The effects according to the embodiments are not limited by the contents exemplified above, and more various effects are included in this disclosure.

### [DESCRIPTION OF DRAWINGS]

FIG. 1 is a plan view schematically illustrating a display device according to one embodiment;
FIG. 2 is a schematic layout view of a circuit lines of a display substrate of a display device according to one embodiment;
FIG. 3 is an equivalent circuit diagram of one pixel of a display device according to one embodiment;
FIG. 4 is an equivalent circuit diagram of one pixel of a display device according to another embodiment;
FIG. 5 is an equivalent circuit diagram of one pixel of a display device according to another embodiment;
FIG. 6 is a cross-sectional view schematically illustrating a display device according to one embodiment;
FIG. 7 is a plan view illustrating an example of emission areas of a display device according to one embodiment;
FIG. 8 is a view illustrating a light emitting element according to one embodiment;
FIG. 9 is a perspective view illustrating a contact area of a second semiconductor layer and a contact electrode of a light emitting element according to one embodiment;
FIG. 10 is an enlarged view of a portion of a light emitting element of a display device according to one embodiment;
FIG. 11 is a diagram illustrating a light emitting element according to another embodiment;
FIG. 12 is a diagram illustrating a light emitting element according to still another embodiment;
FIG. 13 is an enlarged view of a light emitting element area of a display device according to still another embodiment;
FIG. 14 is an enlarged view of a light emitting element area of a display device according to still another embodiment;
FIG. 15 is an enlarged view of a light emitting element area of a display device according to still another embodiment;
FIG. 16 is an enlarged view of a light emitting element area of a display device according to still another embodiment;
FIGS. 17 to 19 are enlarged views of a light emitting element area of a display device according to still another embodiment;
FIG. 20 is a flow chart illustrating a method of manufacturing a display device according to one embodiment; and
FIGS. 21 to 40 are diagrams for explaining a method of manufacturing a display device according to one embodiment.

### [MODES OF THE INVENTION]

The advantages and features of the present invention, and the methods for achieving them, will become apparent with reference to the embodiments described in detail below together with the accompanying drawings. However, the present invention is not limited to the embodiments disclosed hereinafter but will be embodied in various different forms, and these embodiments are merely provided so that the disclosure of the present invention is complete and to fully inform those skilled in the art to which the present invention pertains of the scope of the invention, and the present invention is defined by the scope of the claims.

When an element or a layer is referred to as being "on" another element or layer, this includes both a case where it is directly on the other element, and a case where another layer or element is interposed therebetween. Likewise, references to "below," "left," and "right" of another element also include both cases where they are directly adjacent and cases where another layer or material is interposed therebetween. Throughout the specification, the same reference numerals refer to the same components.

Although terms such as first, second, etc. are used to describe various components, these components are not limited by these terms. These terms are merely used to distinguish one component from another. Thus, a first component mentioned below may also be a second component within the technical spirit of the present invention.

Hereinafter, embodiments of the present disclosure will be described with reference to the drawings.

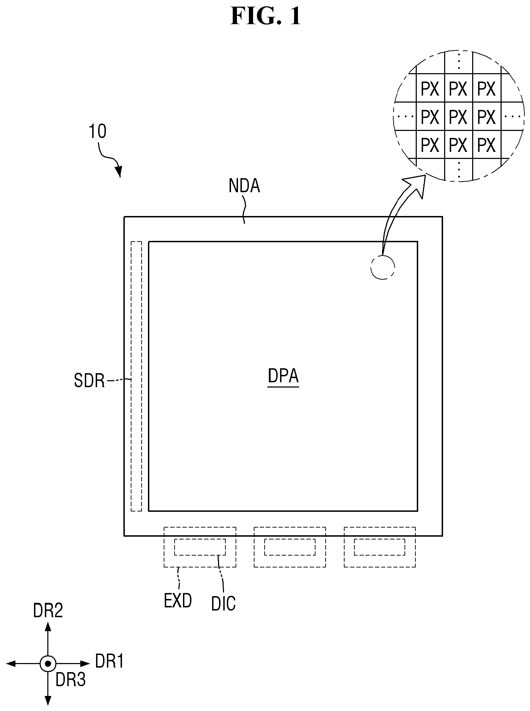

FIG. 1 is a plan view schematically illustrating a display device according to one embodiment.

Referring to FIG. 1, a display device 10 according to one embodiment may be applied to various consumer electronics, or internet of things devices, such as smartphones, cell phones, tablet PC, personal digital assistants (PDA), portable multimedia players (PMP), televisions, gaming devices, watch-type electronic devices, head-mounted displays, monitors of personal computers, laptop computers, car navigation, car instrument panels, digital cameras, camcorders, exterior billboards, billboards, medical devices, inspection devices, refrigerators, and washing machines, and the like. A television is described herein as an example of the display device, and the television may have a high or ultra-high resolution, such as HD, UHD, 4K, 8K, etc.

In addition, the display device 10 according to some embodiments may be variously categorized based on how it is displayed. For example, the classification of the display device may include an organic light emitting display device (OLED), an inorganic light emitting display device (inorganic LED), a quantum dot light emitting display device (QED), a micro-LED display device (micro-LED), a nano-LED display device (nano-LED), a plasma display device (PDP), a field emission display device (FED), a cathode ray tube display device (CRT), a liquid crystal display device (LCD), an electrophoretic display device (EPD), and the like. In the following, the organic light emitting display device will be described as an example of a display device, and the organic light emitting display device applied in an embodiment will be abbreviated simply as a display device unless otherwise indicated. However, embodiments are not limited to organic light emitting display device, and other display devices listed above or known in the art may be employed to the extent that they share technical ideas.

Furthermore, in the following drawings, a first direction DR1 refers to a horizontal direction of the display device 10, a second direction DR2 refers to a vertical direction of the display device 10, and a third direction DR3 refers to a thickness direction of the display device 10. In this case, "left", "right", "up", and "down" refer to directions when the display device 10 is viewed from a plane. For example, "right" refers to one side of the first direction DR1, "left" refers to the other side of the first direction DR1, "top" refers to one side of the second direction DR2, and "bottom" refers to the other side of the second direction DR2. Further, "upper" refers to a first side of the third direction DR3 and "lower" refers to a second side of the third direction DR3.

The display device 10 according to one embodiment may have a square shape in plan view, for example, a square shape. Also, if the display device 10 is a television, it may have a rectangular shape with the long sides disposed in the horizontal direction. However, it is not limited to this, the long sides may be disposed in the vertical direction, and it may be rotatably mounted so that the long sides are variably disposed in the horizontal or vertical direction. The display device 10 may also have a circular or oval shape.

The display device 10 may include a display area DPA and a non-display area NDA around the display area DPA along an edge or a periphery of the display area DPA. The display area DPA may be an active area where the image is displayed. The display area DPA may have a square shape in plan view similar to the overall shape of the display device 10 but is not limited thereto.

The display area DPA may include a plurality of pixels PX. The plurality of pixels PX may be arranged in a matrix format. For example, the plurality of pixels PX may be arranged along rows and columns of a matrix. The shape of each pixel PX may be rectangular or square in plan view, but is not limited thereto, and may also be rhombic in shape with each side inclined toward one side of the display device 10. The plurality of pixels PX may include multiple color pixels PX. For example, the plurality of pixels may include a first color pixel PX of red, a second color pixel PX of green, and a third color pixel PX of blue, but are not limited thereto. Each color pixel PX may be alternately arranged in a stripe-type or a PenTile^{™}.

The non-display area NDA may be disposed on the periphery of the display area DPA. The non-display area NDA may fully or partially enclose the display area DPA. The display area DPA may be square in shape, and the non-display areas NDA may be arranged to be adjacent to the four sides of the display area DPA. The non-display area NDA may comprise a bezel of the display device 10.

A driving circuit or a driving element for driving the display area DPA may be disposed in the non-display area NDA. In one embodiment, the non-display area NDA disposed adjacent to the first side (lower side in FIG. 1) of the display device 10 may have a pad portion provided on the display substrate of the display device 10, and an external device EXD may be mounted on the pad electrode of the pad portion. Examples of the external device EXD include a connection film, a printed circuit board, a driving chip DIC, a connector, a wiring connection film, and the like. In the non-display area NDA disposed adjacent to the second side (left side in FIG. 1) of the display device 10, a scan driving unit SDR, or the like formed directly on the display substrate of the display device 10 may be disposed.

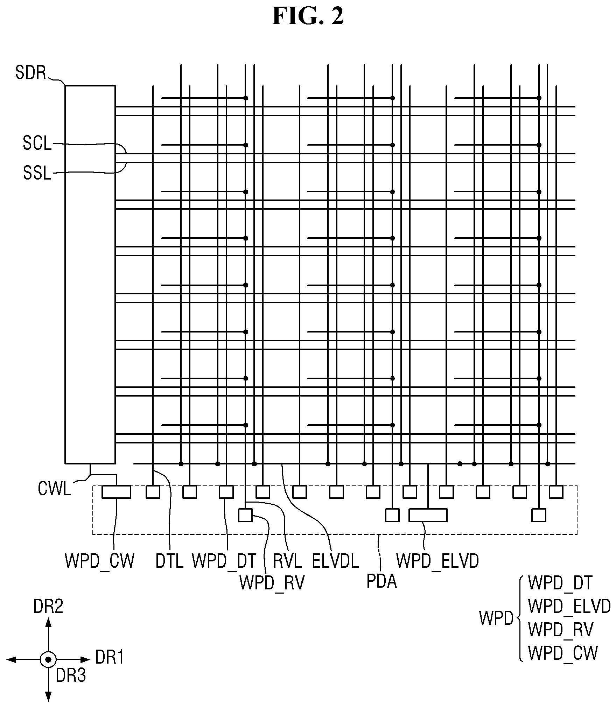

FIG. 2 is a schematic layout view of a circuit lines of a display substrate of a display device according to one embodiment.

Referring to FIG. 2, a plurality of lines is disposed on the substrate. The plurality of lines may include a scan line SCL, a sensing signal line SSL, a data line DTL, a reference voltage line RVL, a first power supply line ELVDL, and the like.

The scan line SCL and the sensing signal line SSL may be extended in the first direction DR1. The scan line SCL and the sensing signal line SSL may be connected to the scan driving unit SDR. The scan driving unit SDR may include a driving circuit. The scan driving unit SDR may be disposed on one side of the non-display area NDA on the display substrate but may also be disposed on both sides of the non-display area NDA. The scan driving unit SDR may be connected to a signal connection line CWL, and at least one end of the signal connection line CWL may be connected to an external device ("EXD" in FIG. 1) by forming a pad WPD_CW on the first non-display area NDA and/or the second non-display area NDA.

The data line DTL and the reference voltage line RVL may be extended in the second direction DR2 intersecting the first direction DR1. The first power supply line ELVDL may include a portion extending in the second direction DR2. The first power supply line ELVDL may further include a portion extending in the first direction DR1. The first power supply line ELVDL may have a mesh structure, but is not limited thereto.

Wiring pads WPD may be disposed at at least one end of the data line DTL, the reference voltage line RVL, and the first power supply line ELVDL. Each wiring pad WPD may be disposed on a pad area PDA of the non-display area (NDA). In one embodiment, a wiring pad (WPD_DT, hereinafter referred to as a "data pad") for a data line DTL, a wiring pad (WPD_RV, hereinafter referred to as a "reference voltage pad") for the reference voltage line RVL, and a wiring pad (WPD_ELVD, hereinafter referred to as a "first power supply pad") for a first power supply line ELVDL may be disposed on the pad area PDA of the non-display area NDA. In another example, the data pad WPD_DT, the reference voltage pad WPD_RV, and the first power supply pad WPD_ELVD may be disposed in different non-display areas NDA. An external device ("EXD" in FIG. 1) may be mounted on the wiring pad WPD as described above. The external device EXD may be mounted on the wiring pad WPD through an anisotropic conductive film, ultrasonic bonding, or the like.

Each pixel PX on the display substrate includes a pixel driving circuit. The wiring described above may pass through or around each pixel PX and apply a driving signal to each pixel driving circuit. The pixel driving circuit may include a transistor and a capacitor. The number of transistors and capacitors in each pixel driving circuit may be varied. Hereinafter, the pixel driving circuit will be described taking a 3T1C structure including three transistors and one capacitor as an example, but is not limited thereto, and various other modified pixel PX structures such as a 2T1C structure, a 7T1C structure, and a 6T1C structure may be applied.

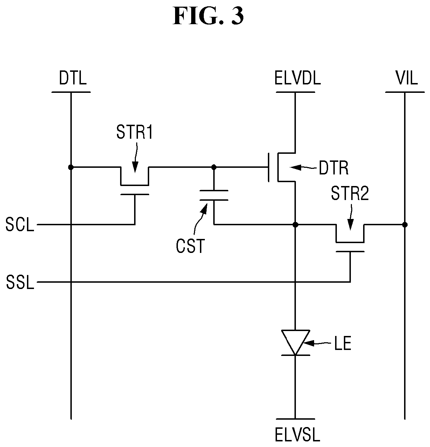

FIG. 3 is an equivalent circuit diagram of one pixel of a display device according to one embodiment.

Referring to FIG. 3, each pixel PX of the display device according to one embodiment includes, in addition to the light emitting element LE, three transistors DTR, STR1 and STR2 and one capacitor CST for storage.

The light emitting element LE emits light in response to a current supplied through a driving transistor DTR. The light emitting element LE may be implemented as an inorganic light emitting diode, an organic light emitting diode, a micro light emitting diode, a nano light emitting diode, or the like.

A first electrode (i.e., an anode electrode) of the light emitting element LE may be connected to a source electrode of the driving transistor DTR, and a second electrode (i.e., a cathode electrode) may be connected to a second power supply line ELVSL supplied with a low potential voltage (second power supply voltage) lower than a high potential voltage (first power supply voltage) of the first power supply line ELVDL.

The driving transistor DTR adjusts the current flowing to the light emitting element LE from the first power supply line ELVDL supplied with the first power supply voltage according to the voltage difference between a gate electrode and the source electrode. The gate electrode of the driving transistor DTR may be connected to the first electrode of a first transistor ST1, the source electrode may be connected to the first electrode of the light emitting element LE, and a drain electrode may be connected to the first power supply line ELVDL to which the first power supply voltage is applied.

The first transistor STR1 is turned-on by a scan signal on the scan line SCL to connect the data line DTL to the gate electrode of the driving transistor DTR. The gate electrode of the first transistor STR1 may be connected to the scan line SL, the first electrode may be connected to the gate electrode of the driving transistor DTR, and the second electrode may be connected to the data line DTL.

A second transistor STR2 is turned-on by a sensing signal on the sensing signal line SSL to connect an initialization voltage line VIL to the source electrode of the driving transistor DTR. The gate electrode of the second transistor ST2 may be connected to the sensing signal line SSL, the first electrode may be connected to the initialization voltage line VIL, and the second electrode may be connected to the source electrode of the driving transistor DTR.

In one embodiment, the first electrode of each of the first and second transistors STR1 and STR2 may be the source electrode and the second electrode may be the drain electrode, but is not limited to, and may be vice versa.

The capacitor CST is formed between the gate and source electrodes of the driving transistor DTR. A storage capacitor CST stores the difference voltage between the gate voltage of the driving transistor DTR and the source voltage.

The driving transistor DTR and the first and second transistors STR1 and STR2 may be formed as thin film transistors. Furthermore, while FIG. 3 describes the driving transistor DTR and the first and second switching transistors STR1 and STR2 as being N-type MOSFET (metal oxide semiconductor field effect transistors), it is not limited to thereto. That is, the driving transistor DTR and the first and second switching transistors STR1 and STR2 may be P-type MOSFET, or some may be N-type MOSFET, and others may be P-type MOSFET.

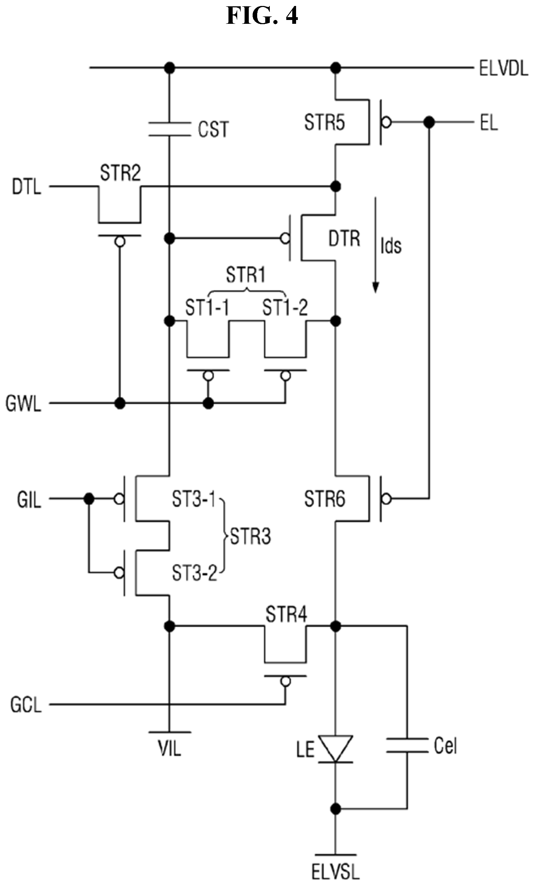

FIG. 4 is an equivalent circuit diagram of one pixel of a display device according to another embodiment.

Referring to FIG. 4, the first electrode of the light emitting element LE may be connected to the first electrode of the fourth transistor STR4 and the second electrode of the sixth transistor STR6, and the second electrode of the light emitting element LE may be connected to the second power supply line ELVSL. A parasitic capacity Cel may be formed between the first electrode and the second electrode of the light emitting element LE.

Each pixel PX includes the driving transistor DTR, switch elements, and the capacitor CST. The switch elements include first to sixth transistors STR1, STR2, STR3, STR4, STR5, and STR6.

The driving transistor DTR includes the gate electrode, the first electrode, and the second electrode. The driving transistor DTR controls the drain-to-source current (Ids, hereinafter referred to as the "driving current") flowing between the first and second electrodes based on the data voltage applied to the gate electrode.

The capacitor CST is formed between the gate electrode of the driving transistor DTR and the first power supply line ELVDL. One electrode of the capacitor CST may be connected to the gate electrode of the driving transistor DTR, and the other electrode may be connected to the first power supply line ELVDL.

When the first electrode of each of the first to sixth transistors STR1, STR2, STR3, STR4, STR5, and STR6 and the driving transistor DTR is the source electrode, the second electrode may be the drain electrode. Alternatively, if the first electrode of each of the first to sixth transistors STR1, STR2, STR3, STR4, STR5, and STR6 and the driving transistor DTR is the drain electrode, the second electrode may be the source electrode.

An active layer of each of the first to sixth transistors STR1, STR2, STR3, STR4, STR5, and STR6 and the driving transistor DTR may be formed from any of poly silicon, amorphous silicon, and oxide semiconductors. When the semiconductor layer of each of the first to sixth transistors STR1, STR2, STR3, STR4, STR5, and STR6 and the driving transistor DTR is formed from poly silicon, the process for forming it may be a low temperature poly silicon (LTPS) process.

In addition, in FIG. 4, the first to sixth transistors STR1, STR2, STR3, STR4, STR5, and STR6 and the driving transistor DTR are described centering on the P-type MOSFET (Metal Oxide Semiconductor Field Effect Transistor), but are not limited thereto, and may be formed as the N-type MOSFET. For example, the first transistor STR1 may be formed of a P-type MOSFET and may include a first-first transistor ST1-1 and a first-second transistor ST1-2 connected to each other. In addition, the third transistor STR3 may be formed of a P-type MOSFET and may include a third-first transistor ST3-1 and a third-second transistor ST3-2 connected to each other.

The gate electrode of the second transistor STR2 and the gate electrode of the first transistor STR1 may be connected to a write scan line GWL, and the gate electrode of the fourth transistor STR4 may be connected to a control scan line GCL. In addition, the gate electrode of the third transistor STR3 may be connected to an initialization scan line GIL. Gate electrodes of the fifth transistor STR5 and the sixth transistor STR6 may be connected to a light emitting line EL. The first power supply voltage of the first power supply line ELVDL, the second power supply voltage of the second power supply line ELVSL, and the third power supply voltage of the third power supply line VIL may be set by considering the characteristics of the driving transistor DTR, the characteristics of the light emitting element LE, and the like.

For example, the first transistor STR1 may be connected between a second electrode and the gate electrode of the driving transistor DTR. The second transistor STR2 may be connected between the data line DTL and a first electrode of the driving transistor DTR. The third transistor STR3 may be connected between the third power supply line VIL and the gate electrode of the driving transistor DTR. The fourth transistor STR4 may be connected between the third power supply line VIL and the light emitting element LE. The fifth transistor STR5 may be connected between the first power supply line ELVDL and the first electrode of the driving transistor DTR. The sixth transistor STR6 may be connected between the second electrode of the driving transistor DTR and the light emitting element LE.

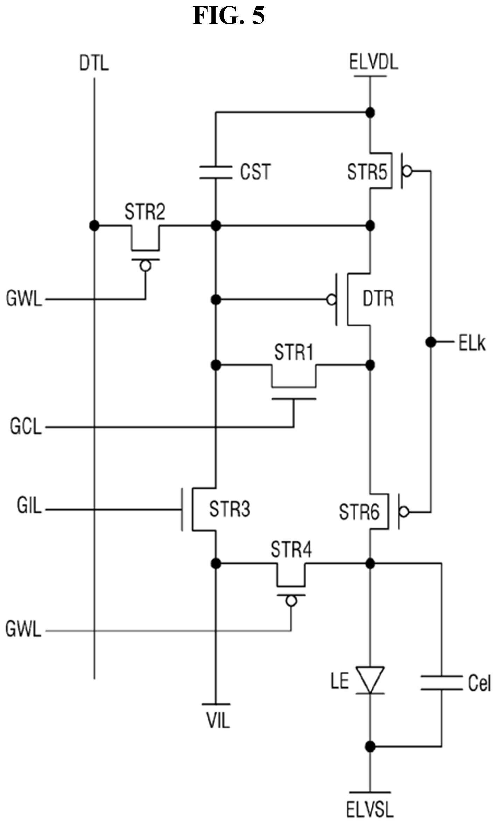

FIG. 5 is an equivalent circuit diagram of one pixel of a display device according to another embodiment.

The embodiment of FIG. 5 differs from the embodiment of FIG. 4 in that the driving transistor DTR, the second transistor STR2, the fourth transistor STR4, the fifth transistor STR5, and the sixth transistor STR6 are formed as the P-type MOSFET, and the first transistor STR1 and the third transistor STR3 are formed as the N-type MOSFET.

Referring to FIG. 5, the active layer of each of the driving transistor DTR, second transistor STR2, fourth transistor STR4, fifth transistor STR5, and sixth transistor STR6 formed as the P-type MOSFET may be formed of polysilicon, and the active layer of each of the first transistor STR1 and third transistor STR3 formed as the N-type MOSFET may be formed of an oxide semiconductor.

FIG. 5 differs from the embodiment of FIG. 4 in that the gate electrode of the second transistor STR2 and the gate electrode of the fourth transistor STR4 are connected to the write scan line GWL, and the gate electrode of the first transistor STR1 is connected to the control scan ling GCL. Also, in FIG. 5, the first transistor STR1 and the third transistor STR3 are formed as the N-type MOSFET, so that the scan signal of the gate high voltage may be applied to the control scan line GCL and the initialization scan line GIL. On the other hand, since the second transistor STR2, the fourth transistor STR4, the fifth transistor STR5, and the sixth transistor STR6 are formed as the P-type MOSFET, the scan signal with a gate low voltage may be applied to the write scan line GWL and the light emitting line EL.

It should be noted that the equivalent circuit diagram of a pixel according to an embodiment of the present disclosure described above is not limited to that shown in FIGS. 3 to 5. The equivalent circuit diagram of a pixel according to an embodiment of the present disclosure may be formed by other known circuit structures that may be employed by those skilled in the art other than the embodiments shown in FIGS. 3 to 5.

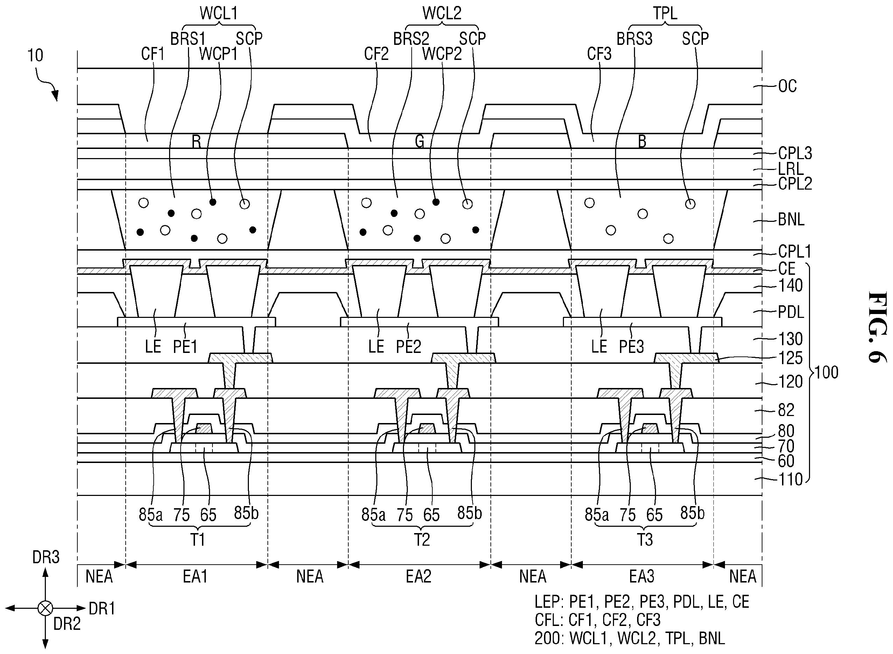

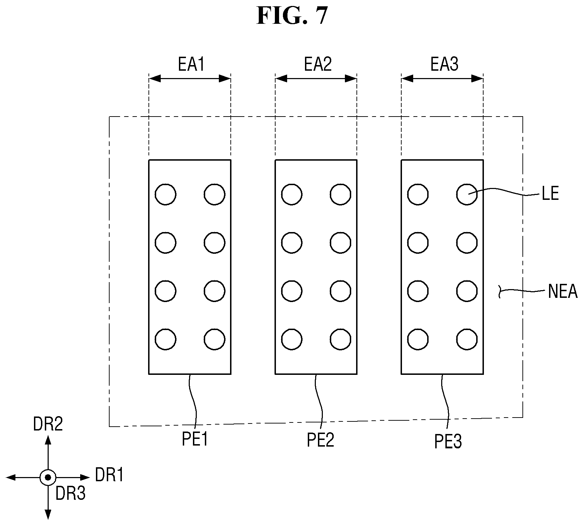

FIG. 6 is a cross-sectional view schematically illustrating a display device according to one embodiment. FIG. 7 is a plan view illustrating an example of emission areas of a display device according to one embodiment.

Referring to FIG. 6, the display device 10 may include a display substrate 100, a wavelength control unit 200 and a color filter layer CFL disposed on the display substrate 100.

The display substrate 100 may include a substrate 110 and a light emitting element part LEP disposed on the substrate 110. The substrate 110 may be an insulating substrate. The substrate 110 may include a transparent material. For example, the substrate 110 may include a transparent insulating material such as glass, quartz, or the like. The substrate 110 may be a rigid substrate. However, the substrate 110 is not limited thereto and may include a plastic, such as polyimide, or the like. Also, the substrate 110 may have flexible characteristics that allow it to be warped, bent, folded, or rolled. A plurality of emission areas EA1, EA2, and EA3 and a non-emission area NEA may be defined on the substrate 110.

Switching elements T1, T2, and T3 may be disposed on the substrate 110. In one embodiment, the first switching element T1 may be disposed in the first emission area EA1 of the substrate 110, the second switching element T2 may be disposed in the second emission area EA2, and the third switching element T3 may be disposed in the third emission area EA3. However, it is not limited to this, and at least one of the first switching element T1, the second switching element T2, and the third switching element T3 may be disposed in the non-emission area NEA in other embodiments.

In one embodiment, the first switching element T1, the second switching element T2, and the third switching element T3 may each be a thin film transistor including an amorphous silicon, polysilicon, or oxide semiconductor. Although not shown, there may be a plurality of signal lines (e.g., gate lines, data lines, power supply lines, etc.) further disposed on the substrate 110 that carry signals to each switching element.

Each switching element T1, T2, and T3 may include a semiconductor layer 65, a gate electrode 75, a source electrode 85a, and a drain electrode 85b. Specifically, a buffer layer 60 may be disposed on the substrate 110. The buffer layer 60 may be disposed to cover a front side of the substrate 110. The buffer layer 60 may include a silicon nitride, a silicon oxide, or a silicon oxynitride, and may be a single layer or a double layer thereof.

The semiconductor layer 65 may be disposed on the buffer layer 60. The semiconductor layer 65 may form a channel of each of the switching elements T1, T2, and T3. The semiconductor layer 65 may include amorphous silicon, polycrystalline silicon, or an oxide semiconductor. In one example, the oxide semiconductor, for example, may include a binary compound (ABx), a ternary compound (ABxCy), or a tetracyclic compound (ABxCyDz) containing indium, zinc, gallium, tin, titanium, aluminium, hafnium (Hf), zirconium (Zr), magnesium (Mg), and the like. In one embodiment, the semiconductor layer 65 may include indium tin zinc oxide (IGZO).

A gate insulating layer 70 may be disposed on the semiconductor layer 65 and the buffer layer 60. The gate insulating layer 70 may include a silicon compound, a metal oxide, or the like. For example, the gate insulating layer 70 may include a silicon oxide, a silicon nitride, a silicon oxynitride, an aluminium oxide, a tantalum oxide, a hafnium oxide, a zirconium oxide, a titanium oxide, and the like. In one embodiment, the gate insulating layer 70 may include a silicon oxide.

The gate electrode 75 may be disposed on the gate insulating layer 70. The gate electrode 75 may overlap the semiconductor layer 65 in a thickness direction. The gate electrode 75 may include a conductive material. The gate electrode 75 may include a metal oxide such as ITO, IZO, ITZO, In₂O₃, or a metal such as copper (Cu), titanium (Ti), aluminium (Al), molybdenum (Mo), tantalum (Ta), calcium (Ca), chromium (Cr), magnesium (Mg), or nickel (Ni). For example, the gate electrode 75 may be formed of a Cu/Ti double layer in which an upper layer of copper is stacked on a lower layer of titanium but is not limited thereto.

A first interlayer insulating layer 80 and a second interlayer insulating layer 82 may be disposed on the gate electrode 75 and the gate insulating layer 70. The first interlayer insulating layer 80 may be directly disposed on the gate electrode 75 and the gate insulating layer 70, and the second interlayer insulating layer 82 may be directly disposed on the first interlayer insulating layer 80. The first interlayer insulating layer 80 and the second interlayer insulating layer 82 each may include an inorganic insulating material such as a silicon oxide, a silicon nitride, a silicon oxynitride, a hafnium oxide, an aluminium oxide, a titanium oxide, a tantalum oxide, a zinc oxide, and the like. However, it is not limited thereto, and the second interlayer insulating layer 82 may include an organic insulating material capable of flattening a lower step.

The source electrode 85a and the drain electrode 85b may be disposed on the second interlayer insulating layer 82. The source electrode 85a and the drain electrode 85b may be connected to the semiconductor layer 65 through contact holes penetrating the first interlayer insulating layer 80, the second interlayer insulating layer 82, and the gate insulating layer 70, respectively. The source electrode 85a and the drain electrode 85b may include metal oxides such as ITO, IZO, ITZO, In₂O₃, or metals such as copper (Cu), titanium (Ti), aluminium (Al), molybdenum (Mo), tantalum (Ta), calcium (Ca), chromium (Cr), magnesium (Mg), and nickel (Ni). For example, the source electrode 85a and the drain electrode 85b may be formed of a Cu/Ti double layer in which an upper layer of copper is stacked on a lower layer of titanium but is not limited thereto.

A first planarization layer 120 may be disposed on the first switching element T1, the second switching element T2, and the third switching element T3. The first planarization layer 120 may include an organic material. For example, the first planarization layer 120 may include an acrylic resin, an epoxy resin, an imide resin, an ester resin, or the like. In one embodiment, the first planarization layer 120 may include a positive photosensitive material or a negative photosensitive material.

A pixel connection electrode 125 may be disposed on the first planarization layer 120. The pixel connection electrode 125 is disposed to correspond to each of the first switching element T1, the second switching element T2, and the third switching element T3, and may be electrically connected to them. The pixel connection electrode 125 may connect pixel electrodes PE1, PE2, and PE3 described later to the switching elements T1, T2, and T3 described above. The pixel connection electrode 125 may contact the switching elements T1, T2, and T3 through a contact hole penetrating the first planarization layer 120.

A second planarization layer 130 may be disposed on the first planarization layer 120 and the pixel connection electrode 125. The second planarization layer 130 flattens the lower step and may include the same material as the first planarization layer 120 described above.

A light emitting element part LEP may be disposed on the second planarization layer 130. The light emitting element part LEP may include a plurality of pixel electrodes PE1, PE2, and PE3, a plurality of light emitting elements LE, and a common electrode CE. Also, the light emitting element part LEP may further include a pixel defining layer PDL and an organic layer 140 that partition each of the emission areas EA1, EA2, and EA3.

The plurality of pixel electrodes PE1, PE2, and PE3 may include a first pixel electrode PE1, a second pixel electrode PE2, and a third pixel electrode PE3. The first pixel electrode PE1, the second pixel electrode PE2, and the third pixel electrode PE3 may serve as the first electrode of the light emitting element LE and may be the anode electrode or the cathode electrode. The first pixel electrode PE1 may be disposed in the first emission area EA1, the second pixel electrode PE2 may be disposed in the second emission area EA2, and the third pixel electrode PE3 may be disposed in the third emission area EA3. In an embodiment, the first pixel electrode PE1 may fully overlap the first emission area EA1, the second pixel electrode PE2 may fully overlap the second emission area EA2, and the third pixel electrode PE3 may fully overlap the third emission area EA3.

Each of the pixel electrodes PE1, PE2, and PE3 may be directly connected to the pixel connection electrode 125 through the contact hole penetrating the second planarization layer 130 and may be electrically connected to each of the switching elements T1, T2, and T3 through the pixel connection electrode 125. The first pixel electrode PE1, the second pixel electrode PE2, and the third pixel electrode PE3 may include metal. The metal may include, for example, copper (Cu), titanium (Ti), silver (Ag), magnesium (Mg), aluminium (Al), platinum (Pt), lead (Pd), gold (Au), nickel (Ni), neodymium (Nd), iridium (Ir), chromium (Cr), lithium (Li), calcium (Ca), or a mixture thereof. Also, the first pixel electrode PE1, the second pixel electrode PE2, and the third pixel electrode PE3 may have a multilayer structure in which two or more metal layers are stacked. For example, the first pixel electrode PE1, the second pixel electrode PE2, and the third pixel electrode PE3 may have a two-layer structure in which a copper layer is stacked on a titanium layer but is not limited thereto.

The plurality of light emitting elements LE may be disposed on each of the first pixel electrode PE1, the second pixel electrode PE2, and the third pixel electrode PE3.

As shown in FIGS. 6 and 7, the light emitting elements LE may be disposed in the first emission area EA1, the second emission area EA2, and the third emission area EA3, respectively. The light emitting element LE may be a vertical light emitting diode element extending long in the third direction DR3. That is, the length of the light emitting element LE in the third direction DR3 may be longer than that in the horizontal direction. The length in the horizontal direction refers to the length of the first direction DR1 or the length of the second direction DR2. A detailed description of the light emitting element LE will be described later.

The organic layer 140 may be disposed on the plurality of pixel electrodes PE1, PE2, and PE3 and the pixel defining layer PDL. The organic layer 140 may flatten a lower step so that the common electrode CE, which will be described later, may be formed. The organic layer 140 may be formed to a predetermined height so that at least a portion of the plurality of light emitting elements LE may protrude above the organic layer 140. That is, the height of the organic layer 140 based on the top surface of the first pixel electrode PE1 may be smaller than the height of the light emitting element LE.

The organic layer 140 may include the organic material to planarize the lower step. For example, the organic layer 140 may include a polyacrylate resin, an epoxy resin, a phenolic resin, a polyamide resin, or a polyimide resin, unsaturated polyester resin, polyphenylenether resin, polyphenylenesulfide resin, or benzocyclobutene (BCB).

The common electrode CE may be disposed on the organic layer 140 and the plurality of light emitting elements LE. In detail, the common electrode CE is disposed on one surface of the substrate 110 on which the light emitting element LE is formed and may be disposed in the entire display area DPA. The common electrode CE is disposed overlapping each of the emission areas EA1, EA2, and EA3 in the display area DPA, and may have a thin thickness so that light may be emitted.

The common electrode CE may be directly disposed on upper and side surfaces of the plurality of light emitting elements LE. For example, the common electrode CE may contact a contact electrode CTE, which is the side surface of the light emitting element LE. The common electrode CE may be a common layer disposed to cover the plurality of light emitting elements LE and to connect the plurality of light emitting elements LE in common.

Since the common electrode CE is entirely disposed on the substrate 110 and a common voltage is applied, the common electrode CE may include a material having low resistance. Also, the common electrode CE may be formed to have a thin thickness to easily transmit light. For example, the common electrode CE may include a low-resistance metal material such as aluminium (Al), silver (Ag), or copper (Cu) or a metal oxide such as ITO, IZO, or ITZO. The common electrode CE may have a thickness of about 10 Å to about 200 Å but is not limited thereto.

The light emitting elements LE may receive a pixel voltage or an anode voltage from each of the pixel electrodes PE1, PE2, and PE3 and may receive a common voltage through the common electrode CE. The light emitting elements LE may emit light with a predetermined luminance according to a voltage difference between the pixel voltage and the common voltage. In one embodiment, it is possible to eliminate the disadvantages of the organic light emitting diode, which is vulnerable to external moisture or oxygen, and improve the lifespan and reliability by disposing a plurality of light emitting elements LE, that is, inorganic light emitting diodes, on the pixel electrodes PE1, PE2, and PE3.

As shown in FIG. 7, the light emitting elements LE may be disposed on each of the pixel electrodes PE1, PE2, and PE3. The light emitting elements LE may be regularly arranged according to a certain rule. For example, the light emitting elements LE may be spaced apart from each other at regular intervals. However, it is not limited thereto, and the light emitting elements LE may be irregularly arranged.

Each of the light emitting elements LE may be substantially disposed on each of the pixel electrodes PE1, PE2, and PE3. However, the present disclosure is not limited thereto, and some light emitting elements LE may be disposed between each pixel electrode PE1, PE2, and PE3, may be partially disposed across any of the pixel electrodes, or may not be disposed on any pixel electrodes.

Meanwhile, a first capping layer CPL1 may be disposed on the substrate 110 on which the common electrode CE is disposed. The first capping layer CPL1 may be directly disposed on the common electrode CE. The first capping layer CPL1 serves to protect components disposed below, e.g., the light emitting elements LE and the common electrode CE, from moisture or debris by covering them.

The first capping layer CPL1 may include an inorganic material. For example, the first capping layer CPL1 may include at least one of silicon nitride, aluminium nitride, zirconium nitride, titanium nitride, hafnium nitride, tantalum nitride, silicon oxide, aluminium oxide, titanium oxide, tin oxide, cerium oxide, and silicon oxide. Meanwhile, although the drawing illustrates that the first capping layer CPL1 is formed of one layer, it is not limited thereto. For example, the first capping layer CPL1 may be formed as multiple layers stacked with alternating inorganic layers including at least one of the materials exemplified as materials that the first capping layer CPL1 may include. The thickness of the first capping layer CPL1 may range from 0.05 µm to 2 µm but is not limited thereto.

Meanwhile, the wavelength control unit 200 may be disposed on the light emitting element part LEP. The wavelength control unit 200 may include a first wavelength conversion layer WCL1, a second wavelength conversion layer WCL2, and a light transmitting layer TPL. Also, the wavelength control unit 200 may further include a bank layer BNL.

The bank layer BNL is disposed on the first capping layer CPL1 and may partition a plurality of emission areas EA1, EA2, and EA3. The bank layer BNL is disposed to extend in the first and second directions DR1 and DR2 and may be formed in a lattice pattern throughout the display area DPA. Also, the bank layer BNL does not overlap with the plurality of emission areas EA1, EA2, and EA3 and may overlap with the non-emission area NEA.

The bank layer BNL may serve to provide a space in which the first wavelength conversion layer WCL1, the second wavelength conversion layer WCL2, and the light transmitting layer TPL are formed. To this end, the bank layer BNL may have a thickness of 1 µm to 10 µm. The bank layer BNL may include an organic insulating material to be formed with a large thickness. The organic insulating material may include, for example, an epoxy-based resin, an acrylic-based resin, a cardo-based resin, or an imide-based resin.

In one embodiment, the bank layer BNL may further include a light blocking material and may include a dye or pigment having light blocking properties. For example, the bank layer BNL may be a black matrix. External light incident from the outside of the display device 10 may cause a problem of distorting the color gamut of the wavelength control unit 200. According to the present embodiment, color distortion due to reflection of external light may be reduced by disposing the bank layer BNL including the light blocking material in the wavelength control unit 200. In addition, the bank layer BNL including the light blocking material may prevent light from penetrating between adjacent emission areas and thus color mixing, thereby further improving color reproducibility.

The first wavelength conversion layer WCL1, the second wavelength conversion layer WCL2, and the light transmitting layer TPL may be disposed on the emission areas EA1, EA2, and EA3. The first wavelength conversion layer WCL1 and the second wavelength conversion layer WCL2 may convert or shift the peak wavelength of incident light into another specific peak wavelength and emit the light. The first wavelength conversion layer WCL1 converts blue light emitted from the light emitting element LE into red light, and the second wavelength conversion layer WCL2 converts blue light into green light. The light transmission layer TP may transmit blue light as it is.

The first wavelength conversion layer WCL1, the second wavelength conversion layer WCL2, and the light transmitting layer TPL may be disposed in each of the emission areas EA1, EA2, and EA3 partitioned by the bank layer BNL, and may be arranged spaced apart from each other. That is, the first wavelength conversion layer WCL1, the second wavelength conversion layer WCL2, and the light transmitting layer TPL may be formed in a dot-shaped island pattern spaced apart from each other.

The first wavelength conversion layer WCL1 may be disposed to overlap the first emission area EA1. The first wavelength conversion layer WCL1 may convert or shift a peak wavelength of incident light into light having another specific peak wavelength and emit the light. In an embodiment, the first wavelength conversion layer WCL1 may convert blue light emitted from the light emitting element LE of the first emission area EA1 into red light having a single peak wavelength in the range of about 610 nm to about 650 nm and emits the converted light.

The first wavelength conversion layer WCL1 may include a first base resin BRS1, first wavelength conversion particles WCP1, and scatterers SCP. The first base resin BRS1 may include a light-transmitting organic material. For example, the first base resin BRS1 may include an epoxy-based resin, an acrylic-based resin, a cardo-based resin, or an imide-based resin.

The first wavelength conversion particle WCP1 may convert blue light incident from the light emitting element LE into red light. For example, the first wavelength conversion particle WCP1 may convert light in a blue wavelength band into light in a red wavelength band. The first wavelength conversion particle WCP1 may be a quantum dot (QD), a quantum rod, a fluorescent material, or a phosphorescent material. For example, the quantum dot may be a particulate material that emits a specific color while electrons transition from a conduction band to a valence band.

The quantum dots may be semiconductor nanocrystalline materials. Depending on its composition and size, the quantum dot may have a specific bandgap to absorb light and emit light with a unique wavelength. Examples of the semiconductor nanocrystals of the quantum dots include IV group nanocrystals, II-VI group compound nanocrystals, III-V group compound nanocrystals, IV-VI group nanocrystals, or combinations thereof.

The group II-VI compound is a binary compound selected from the group consisting of CdSe, CdTe, ZnS, ZnSe, ZnTe, ZnO, HgS, HgSe, HgTe, MgSe, MgS, and mixtures thereof; a ternary compound seleced from the group consisting of InZnP, AgInS, CuInS, CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and mixtures thereof; and a quaternary compound selected from the group consisting of HgZnTeS, CdZnSeS, CdZnSeTe, CdZnSTe, CdHgSeS, CdHgSeTe, CdHgSTe, HgZnSeS, HgZnSeTe, HgZnSTe, and mixtures thereof.

The group III-V compound is a binary compound selected from the group consisting of GaN, GaP, GaAs, GaSb, AlN, AlP, AlAs, AlSb, InN, InP, InAs, InSb, and mixtures thereof; a ternary compound selected from the group consisting of GaNP, GaNAs, GaNSb, GaPAs, GaPSb, AlNP, AlNAs, AlNSb, AlPAs, AlPSb, InGaP, InNP, InAlP, InNAs, InNSb, InPAs, InPSb, GaAlNP, and mixtures thereof; and a quaternary compound selected from the group consisting of GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, and mixtures thereof.

The group IV-VI compounds may be selected from the group consisting of binary compounds selected from the group consisting of SnS, SnSe, SnTe, PbS, PbSe, PbTe, and mixtures thereof; ternary compounds selected from the group consisting of SnSeS, SnSeTe, SnSTe, PbSeS, PbSeTe, PbSTe, SnPbS, SnPbSe, SnPbTe, and mixtures thereof; and a quaternary compound selected from the group consisting of SnPbSSe, SnPbSeTe, SnPbSTe, and mixtures thereof. The group IV element may be selected from the group consisting of Si, Ge, and mixtures thereof. The group IV compound may be a binary compound selected from the group consisting of SiC, SiGe, and mixtures thereof.

The binary, ternary, or quaternary compounds may be present in the particle at a uniform concentration or may be present in the same particle with a partially different concentration distribution. The quantum dot may also have a core/shell structure in which one quantum dot surrounds another. The interface of the core and shell may have a concentration gradient where the concentration of an element present in the shell decreases toward the center.

In one embodiment, the quantum dot may have a core-shell structure including a core including a nanocrystal as described above and a shell surrounding the core. The shell of the quantum dot may act as a protective layer to prevent chemical denaturation of the core to maintain semiconductor properties and/or as a charging layer to impart electrophoretic properties to the quantum dot. The shell may be monolayer or multilayer. Examples of shells for the quantum dots include oxides of metals or non-metals, semiconductor compounds, or combinations thereof.

For example, the oxides of said metals or non-metals may be exemplified by binary compounds such as SiO₂, Al₂O₃, TiO₂, ZnO, MnO, Mn₂O₃, Mn₃O₄, CuO, FeO, Fe₂O₃, Fe₃O₄, CoO, Co₃O₄, NiO, or ternary compounds such as MgAl₂O₄, CoFe₂O₄, NiFe₂O₄, CoMn₂O₄, but the present disclosure is not limited thereto.

In addition, the semiconductor compounds may include CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, etc but are not limited thereto.

The scatterer SCP may scatter the light from the light emitting element LE in a random direction. The scatterer SCP may have a refractive index different from that of the first base resin BRS1 and form an optical interface with the first base resin BRS1. For example, the scatterer SCP may be a light scattering particle. The scatterer SCP is not particularly limited to any material capable of scattering at least a portion of the transmitted light, but may be, for example, metal oxide particles or organic particles. Examples of the metal oxide include titanium oxide (TiO₂), zirconium oxide (ZrO₂), aluminium oxide (Al₂O₃), indium oxide (In₂O₃), zinc oxide (ZnO), tin oxide (SnO₂), and the like, and examples of organic particle materials include acrylic resins or urethane resins. The scatterer SCP may scatter light in the random direction regardless of the incident direction of incident light without substantially converting the wavelength of light.

The second wavelength conversion layer WCL2 may be disposed to overlap the second emission area EA2. The second wavelength conversion layer WCL2 may convert or shift the peak wavelength of incident light into light having another specific peak wavelength and emit the light. In one embodiment, the second wavelength conversion layer WCL2 may convert blue light emitted from the light emitting element LE of the second emission area EA2 into green light having the peak wavelength in a range of about 510 nm to 550 nm and emit the converted light.

The second wavelength conversion layer WCL2 may include a second base resin BRS2 and second wavelength conversion particles WCP2 and scatterers SCP dispersed in the second base resin BRS2.

The second base resin BRS2 may be made of a material having high light transmittance and may be made of the same material as the first base resin BRS1 or may include at least one of the exemplified materials as constituent materials thereof.

The second wavelength conversion particle WCP2 may convert or shift the peak wavelength of incident light to another specific peak wavelength. In one embodiment, the second wavelength conversion particle WCP2 may convert blue light provided from the light emitting element LE into green light having a peak wavelength in a range of about 510 nm to 550 nm and emit it. Examples of the second wavelength conversion particle WCP2 include quantum dots, quantum rods, or phosphors. A more specific description of the second wavelength conversion particle WCP2 is substantially the same as or similar to that described above in the description of the first wavelength conversion particle WCP1, and thus will be omitted.

The light transmitting layer TPL may be disposed to overlap the third emission area EA3. The light transmitting layer TPL may transmit incident light. The light transmitting layer TPL may transmit blue light emitted from the light emitting element LE disposed in the third emission area EA3 as it is. The light transmitting layer TPL may include a third base resin BRS3, and scatterers SCP dispersed in the third base resin BRS3. Since the third base resin BRS3 is substantially the same as or similar to the first base resin BRS1 described above, a description thereof will be omitted.

The light transmitted the wavelength control unit 200 may implement full color by passing through the color filter layer CFL, which will be described later.

The wavelength control unit 200 may further include a second capping layer CPL2. The second capping layer CPL2 covers the first wavelength conversion layer WCL1, the second wavelength conversion layer WCL2, the light transmitting layer TPL, and the bank layer BNL disposed thereunder to protect them from moisture or foreign matter. The second capping layer CPL2 may include an inorganic material and may include a material substantially the same as or similar to that of the first capping layer CPL1 described above.

Meanwhile, a low refractive layer LRL and a third capping layer CPL3 may be disposed on the second capping layer CPL2.

The low refractive layer LRL may be disposed over each of the emission areas EA1, EA2, and EA3 and the non-emission area NEA. The low refractive layer LRL may have a low refractive index. For example, the low refractive index layer LRL may have a refractive index of about 1.1 or more to 1.4 or less.

The low refractive layer LRL may reflect some of the light emitted in the direction from the bottom toward the top (third direction) back to the lower substrate 110. That is, the low refractive layer LRL can improve the light output efficiency by recycling at least some of the light emitted in the upward direction, and as a result, the light efficiency of the display device 10 can be improved. The low refractive index layer LRL may include an organic material and may include particles dispersed therein. The particles may include, for example, hollow silica particles.

The third capping layer CPL3 may be disposed on the low refractive layer LRL. The third capping layer CPL3 can prevent impurities such as moisture or air from penetrating from the outside and damaging or contaminating the low refractive layer LRL.

A color filter layer CFL may be disposed on the third capping layer CPL3. The color filter layer CFL may include a first color filter CF1, a second color filter CF2, and a third color filter CF3.

The first color filter CF1, the second color filter CF2, and the third color filter CF3 may be disposed on the third capping layer CPL3. The first color filter CF1 is disposed in the first emission area EA1, the second color filter CF2 is disposed in the second emission area EA2, and the third color filter CF3 is disposed in the third emission area EA2.

The first color filter CF1, the second color filter CF2, and the third color filter CF3 may include colorants such as dyes or pigments that absorb wavelengths other than the corresponding color wavelengths. The first color filter CF1 may selectively transmit red light and block or absorb blue and green light. The second color filter CF2 may selectively transmit green light and block or absorb blue and red light. The third color filter CF3 may selectively transmit blue light and block or absorb red and green light. For example, the first color filter CF1 may be a red color filter, the second color filter CF2 may be a green color filter, and the third color filter CF3 may be a blue color filter.

In one embodiment, light incident on the first color filter CF1 may be light converted to red light by the first wavelength conversion layer WCL1, and light incident on the second color filter CF2 may be light converted into green light by the second wavelength conversion layer WCL2, and light incident on the third color filter CF3 may be blue light transmitted through the light transmitting layer TPL. As a result, the red light transmitted through the first color filter CF1, the green light transmitted through the second color filter CF2, and the blue light transmitted through the third color filter CF3 may be emitted onto the upper of the substrate 110 to achieve full color.

The first color filter CF1, the second color filter CF2, and the third color filter CF3 may absorb some of the light introduced from the outside of the display device 10 to reduce reflected light caused by external light. Accordingly, the first color filter CF1, the second color filter CF2, and the third color filter CF3 may prevent color distortion due to external light reflection.

In addition, the first color filter CF1 is disposed in the non-emission area NEA, and at least one of the second color filter CF2 and the third color filter CF3 may be further disposed overlapping with each other. That is, the first color filter CF1, the second color filter CF2, and the third color filter CF3 may be disposed in the non-emission area NEA.

Accordingly, light emission from the display device may be blocked in the non-emission area NEA, and reflection of external light may be suppressed. Each color filter CF1, CF2, and CF3 blocks the emission of light of a color other than the corresponding color of each emission area EA1, EA2, and EA3, and accordingly, light of red, green, and blue colors may all be blocked in the non-emission area NEA. However, the present disclosure is not limited thereto, and a light absorbing member including a light absorbing material that a visible light wavelength band may be disposed in the non-emission area NEA.

An overcoat layer OC may be disposed on the color filter layer CFL. The overcoat layer OC may be directly disposed on the color filter layer CFL. The overcoat layer OC may be entirely disposed in the display area DPA and may have a flat surface. The overcoat layer OC may flatten a step formed by the lower color filter layer CFL. The overcoat layer OC may include the light-transmitting organic material.

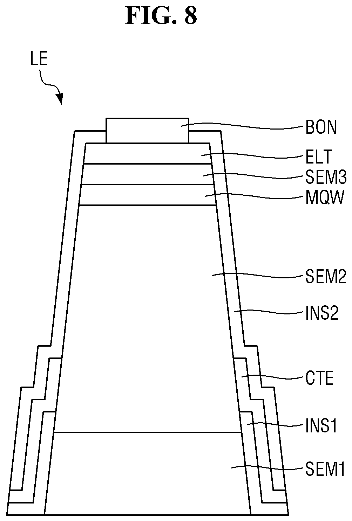

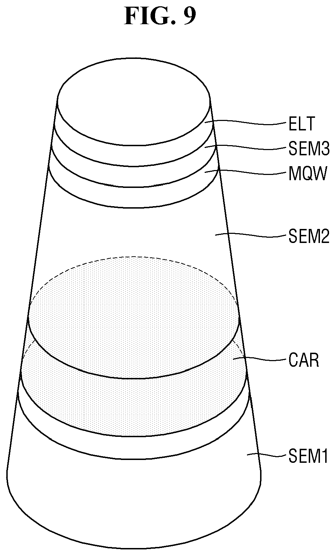

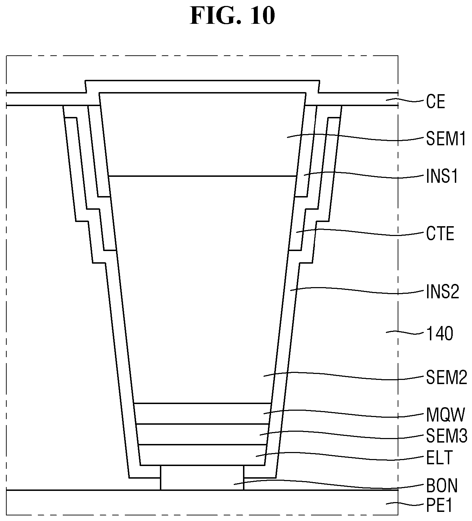

FIG. 8 is a view illustrating a light emitting element according to one embodiment. FIG. 9 is a perspective view illustrating a contact area of a second semiconductor layer and a contact electrode of a light emitting element according to one embodiment. FIG. 10 is an enlarged view of a portion of a light emitting element of a display device according to one embodiment.

Referring to FIGS. 8 to 10, the light emitting element LE is a particulate element, and may have a rod or cylindrical shape having a predetermined aspect ratio. The light emitting element LE may have a size of a nanometer scale (1 nm or more and less than 1 µm) or a micrometer scale (1 µm or more and less than 1 mm). In one embodiment, both the diameter and the length of the light emitting element LE may have a nanometer scale size, or both may have a micrometer scale size. In some other embodiments, the diameter of the light emitting element LE may have a nanometer scale while the length of the light emitting element LE may have a micrometer scale. In some embodiments, some of the light emitting elements LE may have diameters and/or lengths on the nanometer scale, while other portions of the light emitting elements LE may have diameters and/or lengths on the micrometer scale.

In one embodiment, the light emitting element LE may be an inorganic light emitting diode. In detail, the light emitting element LE may include a semiconductor layer doped with any conductive (eg, p-type or n-type) impurity. The semiconductor layer may receive an electrical signal applied from an external power source and emit it as light in a specific wavelength range.

The light emitting element LE according to one embodiment may include a first semiconductor layer SEM1, a second semiconductor layer SEM2, a light emitting layer MQW, a third semiconductor layer SEM2, an element electrode layer ELT, and a connection electrode BON sequentially stacked in the longitudinal direction. In addition, the light emitting element LE may further include a first insulating layer INS1 surrounding outer surfaces of the first semiconductor layer SEM1 and the second semiconductor layer SEM2, a contact electrode CTE surrounding outer surfaces of the first insulating layer INS1 and the second semiconductor layer SEM2, and a second insulating layer INS2 surrounding outer surfaces of the contact electrode CTE, the second semiconductor layer SEM2, the light emitting layer MQW, the third semiconductor layer SEM3, an element electrode layer ELT, and the connection electrode BON.

The first semiconductor layer SEM1 may be an undoped semiconductor and may include a material undoped with n-type or p-type. The first semiconductor layer SEM1 may be a semiconductor material having a chemical formula of AlxGayIn1-x-yN (0≤x≤1, 0≤y≤1, 0≤x+y≤1). For example, the first semiconductor layer SEM1 may be at least one of undoped AlGaInN, GaN, AlGaN, InGaN, AlN, and InN, but is not limited thereto. The length of the first semiconductor layer SEM1 may range from 0.1 µm to 3 µm, but is not limited thereto.

The second semiconductor layer SEM2 may be the n-type semiconductor. When the light emitting element LE emits light in the blue wavelength band, the second semiconductor layer SEM2 may include a semiconductor material having the formula AlxGayIn1-x-yN (0≤x≤1, 0≤y≤1, 0≤x+y≤1). For example, it may be one or more of n-type doped AlGaInN, GaN, AlGaN, InGaN, AlN, and InN. The second semiconductor layer SEM2 may be doped with an n-type dopant, and the n-type dopant may be Si, Ge, Sn, Se, or the like. For example, the second semiconductor layer SEM2 may be n-GaN doped with n-type Si. The length of the second semiconductor layer SEM2 may range from 1.5 µm to 5 µm, but is not limited thereto.

The light emitting layer MQW may be disposed on the second semiconductor layer SEM2. The light emitting layer MQW may emit light by combining electron-hole pairs according to electrical signals applied through the second semiconductor layer SEM2. The light emitting layer MQW may emit light in a blue wavelength band having a central wavelength range of 450 nm to 495 nm.

The light emitting layer MQW may include a single or multiple quantum well structure. If the light emitting layer MQW includes a material with a multi-quantum well structure, it may be a stacked structure with a plurality of well layers and a barrier layer alternating with each other. In this case, the well layer may be formed of InGaN and the barrier layer may be formed of GaN or AlGaN, but is not limited thereto. The thickness of the well layer may be approximately 1 to 4 nm, and the thickness of the barrier layer may be 3 nm to 10 nm.

Alternatively, the light emitting layer MQW may have a structure in which a semiconductor material having a large band gap energy and a semiconductor material having a small band gap energy are alternately stacked with each other and may include other Group 3 to Group 5 semiconductor materials depending on the wavelength band of the emitted light. Light emitted from the light emitting layer MQW is not limited to blue light, and light in a green wavelength band or light in a red wavelength band may be emitted according to circumstances. In one embodiment, when indium is included among the semiconductor materials included in the light emitting layer MQW, the color of emitted light may vary according to the amount of indium.

The third semiconductor layer SEM3 may be disposed on the light emitting layer MQW. The third semiconductor layer SEM3 may be the p-type semiconductor, and may include a semiconductor material having the formula AlxGayIn1-x-yN (0≤x≤1, 0≤y≤1, 0≤x+y≤1). For example, third semiconductor layer SEM3 may be at least one of p-type doped AlGaInN, GaN, AlGaN, InGaN, AlN, and InN. The third semiconductor layer SEM3 may be doped with a p-type dopant, and the p-type dopant may be Mg, Zn, Ca, Ba, or the like. For example, the third semiconductor layer SEM3 may be p-GaN doped with p-type Mg. The length of the third semiconductor layer SEM3 may range from 30 nm to 200 nm but is not limited thereto.

The element electrode layer ELT may be disposed on the third semiconductor layer SEM3. The element electrode layer ELT may be an ohmic connection electrode. However, the present disclosure is not limited thereto, and may be a Schottky connection electrode. The light emitting element LE may include at least one element electrode layer ELT. Although the light emitting element LE including one element electrode layer ELT is illustrated in FIG. 8, the present disclosure is not limited thereto, and may include a plurality of element electrode layers ELT.

The element electrode layer ELT may include conductive metal. For example, the element electrode layer ELT may include at least one of aluminium (Al), titanium (Ti), indium (In), gold (Au), silver (Ag), indium tin oxide (ITO), indium zinc oxide (IZO), or indium tin zinc oxide (ITZO). In addition, the element electrode layer ELT may include an n-type or p-type doped semiconductor material.

The connection electrode BON may serve to transmit a light emitting signal from the first pixel electrode PE1 to the light emitting element LE. The connection electrode BON may be disposed at the top of the light emitting element LE. The connection electrode BON may include at least one of gold (Au), copper (Cu), tin (Sn), silver (Ag), aluminium (Al), and titanium (Ti). For example, the connection electrode BON may include a 9:1 alloy of gold and tin, an 8:2 alloy, or a 7:3 alloy, or may include an alloy of copper, silver, and tin (SAC305).

The first insulating layer INS1 may be disposed to surround the outer surfaces of the first semiconductor layer SEM1, and the second semiconductor layer SEM2 described above. Here, the outer surface may be an outer circumferential surface, an outer surface, or a side surface. For example, the first insulating layer INS1 may be disposed to surround at least an outer surface of the first semiconductor layer SEM1 and extend in one direction in which the light emitting element LE extends. The first insulating layer INS1 may surround the first semiconductor layer SEM1 to prevent the contact electrode CTE from making contact. The first insulating layer INS1 may be formed to surround the side surfaces of the members and but may be disposed to surround the side surface of a portion of the bottom of the second semiconductor layer SEM2. The first insulating layer INS1 may be disposed to surround a portion of the side surface of the second semiconductor layer SEM2 so that the contact electrode CTE is in contact with the outer surface of the second semiconductor layer SEM2.

The first insulating layer INS1 may include an insulating material such as, for example, an oxide, a fluoride, a nitride, or an organic-hybrid material. For example, the first insulating layer INS1 may include at least one of: an oxide such as Al₂O₃, HfO₂, SiO₂, TiO₂, SrTiO₃, Ta₂O₅, Gd₂O₃, ZrO₂, Ga₂O₃, V₂O₅, Co₃O₄, ZnO, ZnO:Al, ZnO:B, In₂O₃:H, WO₃, MoO₃, Nb₂O₅, NiO, MgO, or RuO₂; a fluoride such as MgF₂ or AlF₃; a nitride such as TiN, TaN, Si₃N₄, AlN, GaN, WN, HfN, NbN, GdN, VN, or ZrN; and an organic-hybrid material such as alucone.

The thickness of the first insulating layer INS1 may range from 0.5 nm to 1.0 µm but is not limited thereto. Preferably, the first insulating layer INS1 may range from 10 nm to 30 nm.

The contact electrode CTE may be arranged to surround the outer surfaces of the first insulating layer INS1 and the second semiconductor layer SEM2. For example, the contact electrode CTE may be disposed to surround at least the outer surface of the first insulating layer INS1 and contact a portion of the outer surface of the second semiconductor layer SEM2. The contact electrode CTE may extend from the bottom of the light emitting element LE in one direction in which the light emitting element LE extends. The contact electrode CTE may be spaced apart from the first semiconductor layer SEM1 by the first insulating layer INS1 and may not be in contact with the first semiconductor layer SEM1. The contact electrode CTE may be disposed to contact the second semiconductor layer SEM2 and may serve to transmit a low potential voltage applied from the common electrode CE to the light emitting element LE.

The contact electrode CTE may include conductive metal. For example, the contact electrode layer CTE may include at least one of aluminium (Al), titanium (Ti), indium (In), gold (Au), silver (Ag), indium tin oxide (ITO), indium zinc oxide (IZO), or indium tin zinc oxide (ITZO).

In addition, the contact electrode CTE may be in contact with a portion of the bottom of the light emitting element LE. The light emitting element LE may have a contact area CAR where the contact electrode CTE2 and the second semiconductor layer SEM2 are in contact with each other. The contact area CAR may be disposed in a partial area of the second semiconductor layer SEM2. For example, the contact area CAR may be disposed in an area ranging from 1 to 50% of the length of the second semiconductor layer SEM2 from the interface between the first semiconductor layer SEM1 and the second semiconductor layer SEM2. However, the present disclosure is not limited thereto, and the contact area CAR may be disposed in an area ranging from 1 to 90% of the length of the second semiconductor layer SEM2 from the interface between the first semiconductor layer SEM1 and the second semiconductor layer SEM2. In addition, the contact area CAR may be disposed in the entire area of the second semiconductor layer SEM2.

The area of the contact area CAR may be adjusted considering the contact resistance between the contact electrode CTE and the second semiconductor layer SEM2. For example, the area of the contact area CAR may range from 10 to 50% of the total area of the outer surface of the second semiconductor layer SEM2. However, the present disclosure is not limited thereto, and the area of the contact area CAR may range from 1 to 90% of the total area of the outer surface of the second semiconductor layer SEM2. In addition, the area of the contact area CAR may be equal to the total area of the outer surface of the second semiconductor layer SEM2.

The second insulating layer INS2 may be disposed to cover the outer surfaces of the second semiconductor layer SEM2, the light emitting layer MQW, the first semiconductor layer SEM1, the element electrode layer ELT, the connection electrode BON, and the contact electrode CTE. For example, the second insulating layer INS2 may be disposed to surround at least the outer surface of the light emitting layer MQW and extend in one direction in which the light emitting element LE extends. The second insulating layer INS2 may serve to insulate and protect the second semiconductor layer SEM2, the light emitting layer MQW, the first semiconductor layer SEM1, the element electrode layer ELT, the connection electrode BON, and the contact electrode CTE. The second insulating layer INS2 may be formed to surround the side surfaces of the members, but may be formed to expose both ends of the light emitting element LE in the longitudinal direction. For example, the second insulating layer INS2 may expose a portion of the connection electrode BON disposed at the upper end of the light emitting element LE, and expose a portion of each of the first semiconductor layer SEM1, the first insulating layer INS1 and the contact electrode CTE disposed at the lower end of the light emitting element LE. A portion of the side surface of the second insulating layer INS2 may be aligned with a portion of the side surface of the contact electrode CTE and a portion of the side surface of the first insulating layer INS1. In some embodiments, a portion of the side surface of the second insulating layer INS2 may coincide with a portion of the side surface of the contact electrode CTE and a portion of the side surface of the first insulating layer INS1. However, the present disclosure is not limited to thereto, and a portion of the side surface of the second insulating layer INS2 may not coincide with a portion of the side surface of the contact electrode CTE and a portion of the side surface of the first insulating layer INS1. The second insulating layer INS2 may not be in contact with the first insulating layer INS1.

The second insulating layer INS2 may include an insulating material such as, for example, an oxide, a fluoride, a nitride, or an organic-hybrid material. For example, the second insulating layer INS2 may include at least one of: an oxide such as Al₂O₃, HfO₂, SiO₂, TiO₂, SrTiO₃, Ta₂O₅, Gd₂O₃, ZrO₂, Ga₂O₃, V₂O₅, Co₃O₄, ZnO, ZnO:Al, ZnO:B, In₂O₃:H, WO₃, MoO₃, Nb₂O₅, NiO, MgO, or RuO₂; a fluoride such as MgF₂ or AlF₃; a nitride such as TiN, TaN, Si₃N₄, AlN, GaN, WN, HfN, NbN, GdN, VN, or ZrN; and an organic-hybrid material such as alucone.

The thickness of the second insulating layer INS2 may range from 0.5 nm to 1.0 µm but is not limited thereto. Preferably, the second insulating layer INS2 may range from 10 nm to 30 nm.

In one embodiment, the second insulating layer INS2 may be formed of a single layer or multiple layers of materials having insulating properties. One or more insulating layers may prevent oxygen constituting the second insulating layer INS2 from diffusing and deteriorating the second semiconductor layer SEM2, the light emitting layer MQW, and the third semiconductor layer SEM3 of the light emitting element LE. The second insulating layer INS2 may prevent an electrical short circuit that may occur when the light emitting layer MQW directly contacts an electrode through which an electrical signal is transmitted to the light emitting element LE. In addition, since the second insulating layer INS2 protects the outer surface of the light emitting element LE by including the light emitting layer MQW, a decrease in light emitting efficiency may be prevented.

As shown in FIG. 10, the light emitting element LE described above may be combined and disposed on the first pixel electrode PE1. Specifically, the connection electrode BON of the light emitting element LE may be in direct contact with the first pixel electrode PE1 to transmit a light emitting signal from the first pixel electrode PE1. An organic layer 140 surrounding the light emitting elements LE may be disposed around the light emitting elements LE, and expose the first semiconductor layer SEM1, the first insulating layer INS1, and the contact electrode CTE which is one end of the light emitting element LE. In FIG. 10, the upper portion of the first insulating layer INS1 of the light emitting element LE of FIG. 8 is illustrated as partially removed. This structural difference is removed in the subsequent process after the light emitting element LE is manufactured, and will be explained in detail in the manufacturing method which will be described later.

A common electrode CE may be disposed on the light emitting element LE and the organic layer 140. The common electrode CE may cover the light emitting element LE and the organic layer 140. The common electrode CE may be in direct contact with the top surface of the first semiconductor layer SEM1, the top surface of the first insulating layer INS1, and the top surface of the contact electrode CTE. When the common electrode CE is in contact with the contact electrode CTE, the low potential voltage of the common electrode CE may be transmitted to the light emitting element LE. For example, the low potential voltage transmitted from the common electrode CE may be transmitted through the contact electrode CTE to the second semiconductor layer SEM2 in contact with the contact electrode CTE.

As will be described later, the first semiconductor layer SEM1 is essentially formed to reduce the difference in lattice constant between a sapphire substrate and the second semiconductor layer SEM2 during the manufacturing process of the light emitting element LE. However, since the first semiconductor layer SEM1 is not doped and has an extremely high resistance, an etching process of the first semiconductor layer SEM1 must be performed after combining the light emitting element LE on the pixel electrode of the display substrate. The process of etching the first semiconductor layer SEM1 on the display substrate is highly difficult to accurately etch the first semiconductor layer SEM1 in case where layers other than the first semiconductor layer SEM1 are etched or the light emitting element LE is tilted.

In the light emitting element LE according to the embodiment described above, the contact electrode CTE may be in contact with the outer surface (or side surface) of the second semiconductor layer SEM2, and a low potential voltage may be applied from the common electrode CE. Accordingly, since the light emitting element LE can be normally driven even with the first semiconductor layer SEM1, there is an advantage in that the etching process of the first semiconductor layer SEM1 can be omitted.

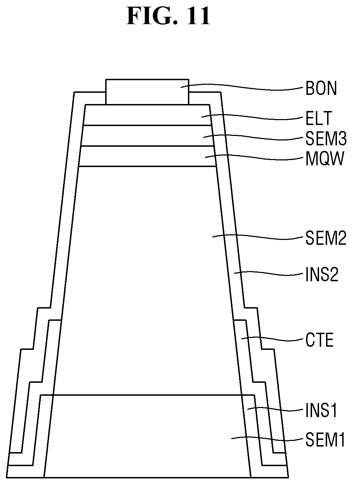

FIG. 11 is a diagram illustrating a light emitting element according to another embodiment.

Referring to FIG. 11, the present embodiment is different from the embodiments of FIGS. 6 to 10 in that the first insulating layer INS1 is disposed only on the outer surface of the first semiconductor layer SEM1. Hereinafter, descriptions of the same components will be simplified or omitted, and differences will be described in detail.

The first insulating layer INS1 may be disposed to surround the outer surface of the first semiconductor layer SEM1 of the light emitting element LE. The first insulating layer INS may be formed to surround the side portion of the first semiconductor layer SEM1, but may not surround the outer surfaces of the second semiconductor layer SEM2, the light emitting layer MQW, the third semiconductor layer SEM3 and the element electrode layer ELT of the light emitting element LE. The top surface of the first insulating layer INS1 may be aligned with the top surface of the first semiconductor layer SEM1. In some embodiments, the top surface of the first insulating layer INS1 may coincide with the top surface of the first semiconductor layer SEM1. However, the present disclosure is not limited thereto, and the top surface of the first insulating layer INS1 may not coincide with the top surface of the first semiconductor layer SEM1. The first insulating layer INS1 may not be in contact with the second semiconductor layer SEM2. The first insulating layer INS1 may function to insulate between the first semiconductor layer SEM1 and the contact electrode CTE. For example, the first insulating layer INS1 prevents the contact electrode CTE from contacting the first semiconductor layer SEM1.

The contact electrode CTE may extend from the interface between the first semiconductor layer SEM1 and the second semiconductor layer SEM2 in the longitudinal direction of the second semiconductor layer SEM2 and contact the second semiconductor layer SEM2. Since the first insulating layer INS1 surrounds only the outer surface of the first semiconductor layer SEM1, the contact area of the contact electrode CTE contacting the second semiconductor layer SEM2 can be increased. Accordingly, the contact area between the second semiconductor layer SEM2 and the contact electrode CTE may be increased, thereby improving the efficiency of the light emitting element LE.

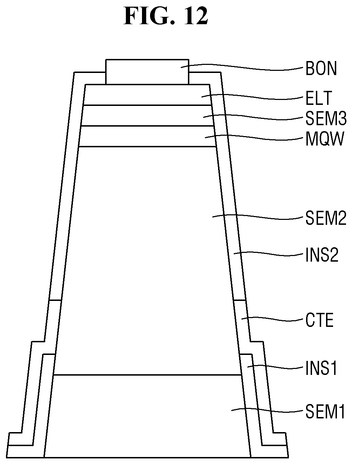

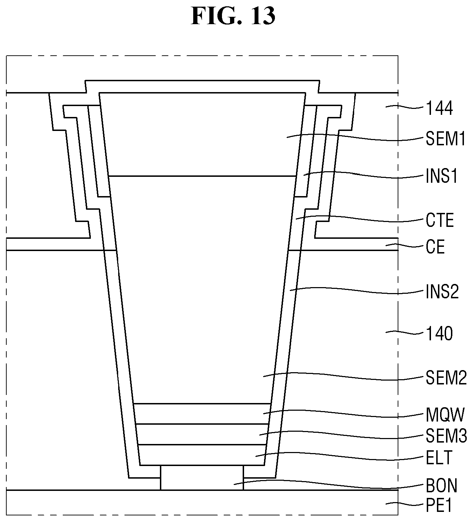

FIG. 12 is a diagram illustrating a light emitting element according to still another embodiment. FIG. 13 is an enlarged view of a light emitting element area of a display device according to still another embodiment.

Referring to FIGS. 12 and 13, the light emitting element LE according to the present embodiment differs from the embodiments of FIGS. 6 to 10 described above in that the second insulating layer INS2 does not surround the outer surface of the contact electrode CTE and further including a second organic layer 144.

Specifically, the second insulating layer INS2 may be disposed to surround the outer surface of the second semiconductor layer SEM2, the light emitting layer MQW, the third semiconductor layer SEM3, the element electrode layer ELT, and the connection electrode BON of the light emitting element LE. The second insulating layer INS2 may be formed to surround a portion of the outer surface of the second semiconductor layer SEM2, but may not surround the outer surface of the contact electrode CTE of the light emitting element LE. The lower surface of the second insulating layer INS2 may be in contact with the top surface of a contact electrode CTE3. The side surface of the second insulating layer INS2 may be aligned with the side surface of the contact electrode CTE3. In some embodiments, the side surface of the second insulating layer INS2 may coincide with the side surface of the contact electrode CTE3. However, the present disclosure is not limited thereto, and the side surface of the second insulating layer INS2 may not coincide with the side surface of the contact electrode CTE3. The second insulating layer INS2 may serve to protect the light emitting element LE, but the contact electrode CTE and the first insulating layer INS1 may be disposed in the area where the second insulating layer INS2 is not disposed to protect the light emitting element LE.

The light emitting element LE described above may be coupled to the first pixel electrode PE1. The first organic layer 140 disposed on the first pixel electrode PE1 may surround the light emitting element LE and expose a portion of the light emitting element LE. Specifically, the first organic layer 140 may cover the connection electrode BON and the second insulating layer INS2 of the light emitting element LE. The contact electrode CTE, the first insulating layer INS1, and first semiconductor layer SEM1 of the light emitting element LE may be exposed without being covered by the organic layer 140. The top surface of the organic layer 140 may be aligned with the top surface of the second insulating layer INS2 of the light emitting element LE. For example, the top surface of the organic layer 140 and the top surface of the second insulating layer INS2 may be disposed on the same line. In some embodiments, the top surface of the organic layer 140 may coincide with the top surface of the second insulating layer INS2 of the light emitting element LE. However, the present invention is not limited thereto, and the top surface of the organic layer 140 may not coincide with the top surface of the second insulating layer INS2 of the light emitting element LE.

The common electrode CE may be disposed on the light emitting element LE and the organic layer 140. The common electrode CE may cover the light emitting element LE to cover the first semiconductor layer SEM1, the first insulating layer INS1, and the contact electrode CTE of the light emitting element LE and directly contact them. Specifically, the common electrode CE may cover and contact the entire outer surface of the contact electrode CTE, thereby improving the efficiency of the light emitting element LE by reducing the contact resistance between the common electrode CE and the contact electrode CTE.

The second organic layer 144 may be disposed on the first organic layer 140. The second organic layer 144 may be in contact with the top surface of the common electrode CE and formed to be aligned with the top surface of the light emitting element LE. In some embodiments, the top surface of the second organic layer 144 may coincide with the top surface of the light emitting element LE. However, the present disclosure is not limited thereto, and the top surface of the second organic layer 144 may not coincide with the top surface of the light emitting element LE. The second organic layer 144 may function to flatten the lower step of the common electrode CE.

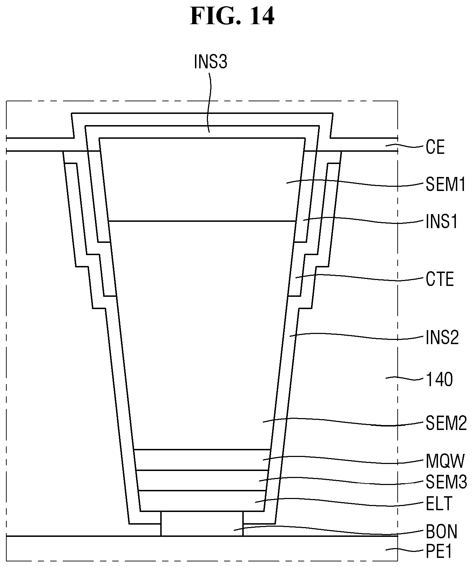

FIG. 14 is an enlarged view of a light emitting element area of a display device according to still another embodiment.

Referring to FIG. 14, the display device 10 of the present embodiment differs from the embodiments of FIGS. 6 to 10 described above in that a third insulating layer INS3 is further disposed between the common electrode CE and the light emitting element LE.

The third insulating layer INS3 may be disposed on the light emitting element LE. The third insulating layer INS3 may be disposed on the first semiconductor layer SEM1 and the first insulating layer INS1 of the light emitting element LE. The third insulating layer INS3 may be disposed to be spaced apart from the contact electrode CTE so as to cover the first semiconductor layer SEM1 and the first insulating layer INS1 but not to cover the contact electrode CTE.

The third insulating layer INS3 may be disposed between the common electrode CE and the first semiconductor layer SEM1 and may perform the function of preventing the common electrode CE and the first semiconductor layer SEM1 from contacting each other. As described above, since the first semiconductor layer SEM1 is not doped and has a very high resistance, the resistance between the common electrode CE and the light emitting element LE increases, thereby reducing efficiency. Accordingly, as the third insulating layer INS3 is disposed between the common electrode CE and the first semiconductor layer SEM1 so that the common electrode CE is not in contact with the first semiconductor layer SEM1, the low potential voltage of the common electrode CE can be transmitted only to the contact electrode CTE.

The common electrode CE may be disposed on the light emitting element LE, the third insulating layer INS3, and the organic layer 140. The common electrode CE may contact the contact electrode CTE exposed around the third insulating layer INS3. Accordingly, the efficiency of the light emitting element LE can be increased by allowing the low potential voltage applied from the common electrode CE to be transmitted to the contact electrode CTE.

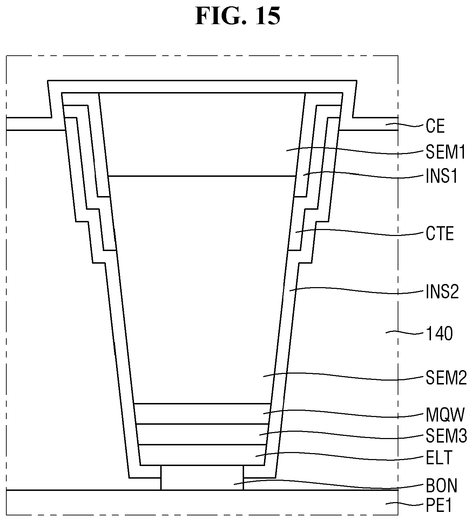

FIG. 15 is an enlarged view of a light emitting element area of a display device according to still another embodiment.

Referring to FIG. 15, the display device 10 of the present embodiment differs from the embodiments of FIGS. 6 to 10 described above in that a first insulating layer INS1 covers the top surface of the contact electrode CTE.

The light emitting element LE may have the same structure as that of FIG. 8 described above. Specifically, the first insulating layer INS1 may be disposed on the top of the light emitting element LE. The top surface of the first insulating layer INS1 may be aligned with the top surface of the first semiconductor layer SEM1. In some embodiments, the top surface of the first insulating layer INS1 may coincide with the top surface of the first semiconductor layer SEM1. However, the present disclosure is not limited thereto, and the top surface of the first insulating layer INS1 may not coincide with the top surface of the first semiconductor layer SEM1.

The organic layer 140 may be disposed to surround the light emitting element LE, and may be disposed not to cover the side surfaces of the first insulating layer INS1, the contact electrode CTE, and the second insulating layer INS2 so that they are exposed. For example, the height of the organic layer 140 may be lower than the height of the side surface of the contact electrode CTE exposed on the side surface of the light emitting element LE. However, the present disclosure is not limited thereto, and the height of the organic layer 140 may be formed to be the same as the height of the second insulating layer INS2.

The common electrode CE covers the light emitting element LE and may directly contact the contact electrode CTE exposed on the side of the light emitting element LE. That is, since the organic layer 140 does not cover the side surface of the contact electrode CTE, the common electrode CE may directly contact the side surface of the contact electrode CTE. Accordingly, a low potential voltage can be transmitted from the common electrode CE to the light emitting element LE through the contact electrode CTE.

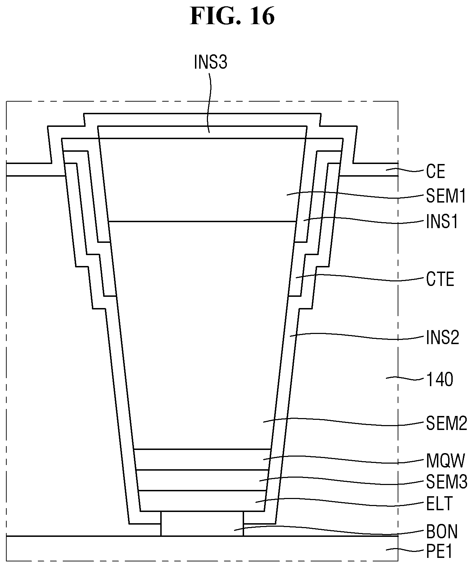

FIG. 16 is an enlarged view of a light emitting element area of a display device according to still another embodiment.

Referring to FIG. 16, the display device 10 of the present embodiment differs from the embodiment of FIG. 15 described above in that a third insulating layer INS3 is disposed on the first semiconductor layer SEM1 of the light emitting element LE.

The third insulating layer INS3 may be disposed on the light emitting element LE. The third insulating layer INS3 may be disposed on the first semiconductor layer SEM1 and be disposed to be spaced apart from the first insulating layer INS1. The third insulating layer INS3 may be disposed directly on the top surface of the first semiconductor layer SEM1.

As described above, the third insulating layer INS3 is disposed between the common electrode CE and the first semiconductor layer SEM1 to perform preventing the common electrode CE and the first semiconductor layer SEM1 from contacting each other. Accordingly, the third insulating layer INS3 is disposed between the common electrode CE and the first semiconductor layer SEM1 so that the low potential voltage of the common electrode CE can be transmitted only to the contact electrode CTE.

The common electrode CE may be disposed on the light emitting element LE, the third insulating layer INS3, and the organic layer 140. The common electrode CE may be in contact with the contact electrode CTE exposed on the side of the light emitting element LE. Accordingly, the efficiency of the light emitting element LE can be increased by allowing the low potential voltage applied from the common electrode CE to be transmitted to the contact electrode CTE.

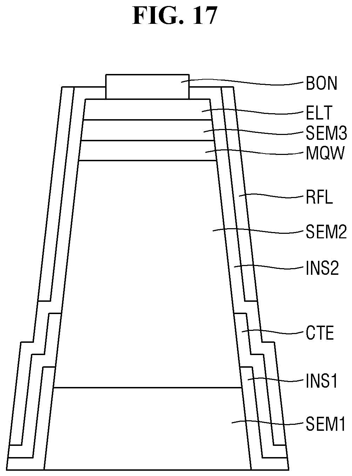

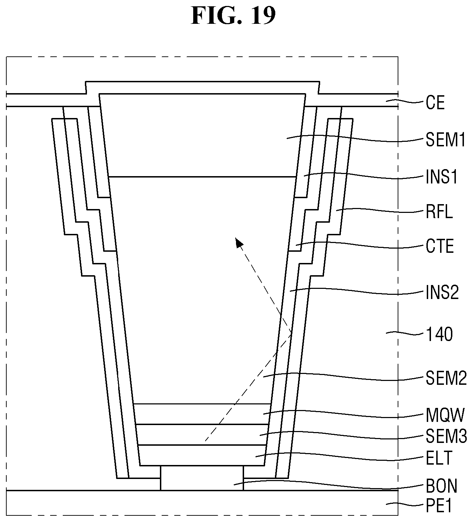

FIGS. 17 to 19 are enlarged views of a light emitting element area of a display device according to still another embodiment.

Referring to FIGS. 17 to 19, the display device 10 of the present embodiments differ from the embodiments of FIGS. 8 to 10 described above in further including a reflective layer RFL.

The reflective layer RFL may be disposed to surround the outer surface of the second insulating layer INS2. For example, the reflective layer RFL may be arranged to surround the outer surface of the second insulating layer INS2 and may extend in one direction in which the light emitting element LE extends. The reflective layer RFL may perform a function of reflecting light emitted from the light emitting layer MQW and allowing the light to be emitted in the direction of the first semiconductor layer SEM1. The reflective layer RFL may be disposed to correspond to the outer surfaces of the second semiconductor layer SEM2, the light emitting layer MQW, the third semiconductor layer SEM3, and the element electrode layer ELT of the light emitting element LE. When the contact electrode CTE is formed of a reflective material, the reflective layer RFL may not be disposed in an area corresponding to the outer surface of the contact electrode CTE because the contact electrode CTE functions as a reflective layer.

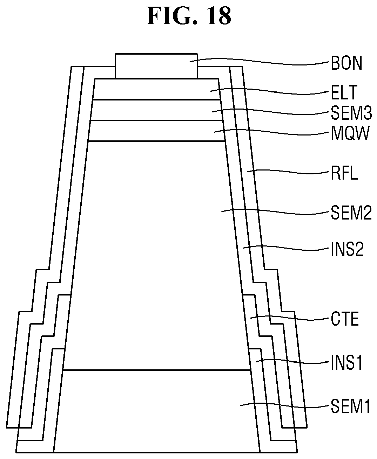

As another example, as shown in FIG. 18, the reflective layer RFL may be disposed on the outer surface of the second insulating layer INS2 corresponding to the outer surface of the contact electrode CTE. The reflective layer RFL may be disposed on the entire outer surface of the second insulating layer INS1.

The reflective layer RFL may be a distributed Bragg reflector (DBR). The reflective layer RFL may include a plurality of layers to act as a distributed Bragg reflector. The plurality of layers may be arranged alternately with high refractive index layers and low refractive index layers.

The reflective layer RFL may include an insulating material such as, for example, an oxide, a fluoride, a nitride, or an organic-hybrid material. For example, the reflective layer RFL may include at least one of: an oxide such as Al₂O₃, HfO₂, SiO₂, TiO₂, SrTiO₃, Ta₂O₅, Gd₂O₃, ZrO₂, Ga₂O₃, V₂O₅, Co₃O₄, ZnO, ZnO:Al, ZnO:B, In₂O₃:H, WO₃, MoO₃, Nb₂O₅, NiO, MgO, or RuO₂; a fluoride such as MgF₂ or AlF₃; a nitride such as TiN, TaN, Si₃N₄, AlN, GaN, WN, HfN, NbN, GdN, VN, or ZrN; and an organic-hybrid material such as alucone. The thickness of the reflective layer RFL may range from 0.5 µm to 1.0 µm but is not limited thereto.

In the present embodiment, by including the reflective layer RFL surrounding the outer surface of the light emitting element LE, the light emitting efficiency of light emitted from the light emitting layer MQW of the light emitting element LE can be improved.

Hereinafter, a manufacturing process of the display device 10 according to one embodiment will be described with reference to other drawings.

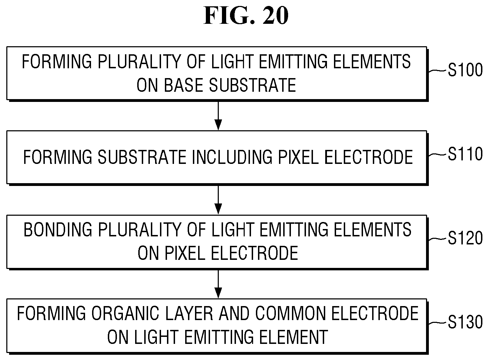

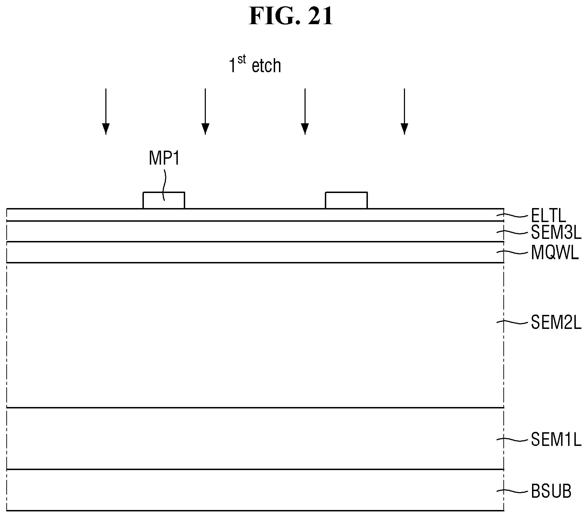

FIG. 20 is a flow chart illustrating a method of manufacturing a display device according to one embodiment. FIGS. 21 to 40 are diagrams for explaining a method of manufacturing a display device according to one embodiment.

FIGS. 21 to 40 are cross-sectional views illustrating structures corresponding to the sequence of formation of the respective layers of the display device 10. FIGS. 21 to 40 mainly illustrate manufacturing processes of the light emitting element part LEP of the display device 10, and they may generally correspond to the cross-sectional view of FIG. 6. Further, hereinafter, the first emission area EA1 of the display device 10 will be described as an example. Hereinafter, a method of manufacturing the display device shown in FIGS. 21 to 40 will be described in conjunction with FIG. 20.

Referring to FIG. 20, the method of manufacturing the display device 10 according to one embodiment may include forming a plurality of light emitting elements on a base substrate (step S100), forming a substrate including a pixel electrode (step S110), bonding the plurality of light emitting elements on the pixel electrode (step S120), and forming an organic layer and a common electrode on the light emitting element (step S130).

First, referring to FIG. 21, a plurality of element rods LEL are formed on a base substrate BSUB.

Specifically, the base substrate BSUB is prepared. The base substrate BSUB may be a sapphire substrate (Al₂O₃) or a silicon wafer containing silicon. However, the present disclosure is not limited thereto, and in one embodiment, a case in which the base substrate BSUB is a sapphire substrate will be described as an example.

A plurality of semiconductor material layers SEM1L, SEM2L, MQML, and SEM3L are formed on the base substrate BSUB. The plurality of semiconductor material layers may be formed by growing seed crystals grown by an epitaxial method. Here, the semiconductor material layer may be formed using one of electron beam deposition, physical vapor deposition (PVD), chemical vapor deposition (CVD), plasma laser deposition (PLD), dual-type thermal evaporation, sputtering, and metal organic chemical vapor deposition (MOCVD), preferably, using the metal organic chemical vapor deposition (MOCVD). However, the present disclosure is not limited thereto.

Typically, a precursor material for forming the plurality of semiconductor material layers may be selected to form a target material in a typically selectable range without any limitation. For example, the precursor material may be a metal precursor including an alkyl group such as a methyl group or an ethyl group. Examples of the precursor material may include, but are not limited to, trimethyl gallium Ga(CH₃)₃, trimethyl aluminium Al(CH₃)₃, and triethyl phosphate (C₂H₅)₃PO₄.

Specifically, the first semiconductor material layer SEM1L is formed on the base substrate BSUB. Although it is shown in the drawing that one first semiconductor material layer SEM1L is deposited, the present disclosure is not limited thereto, and a plurality of layers may be formed. The first semiconductor material layer SEM1L may be disposed to reduce a lattice constant difference between the second semiconductor material layer SEM2L and the base substrate BSUB. As one example, the first semiconductor material layer SEM1L may include an undoped semiconductor, and may be a material not doped with an n-type or p-type. In an embodiment, the first semiconductor material layer SEM1L may be, but is not limited to, at least one of undoped InAlGaN, GaN, AlGaN, InGaN, AlN, or InN.

The second semiconductor material layer SEM2L, the light emitting material layer MQWL, and the third semiconductor material layer SEM3L are sequentially formed on the first semiconductor material layer SEM1L using the above-described method.

Next, an element electrode material layer ELTL is stacked on the third semiconductor material layer SEM3L.

Subsequently, a plurality of first mask patterns MP1 are formed on the element electrode material layer ELTL. The first mask pattern MP1 may be a hard mask including an inorganic material or a photoresist mask including an organic material. The first mask pattern MP1 prevents the plurality of semiconductor material layers SEM1L, SEM2L, MQWL, and SEM3L and the element electrode material layer ELTL disposed below from being etched. Then, a first etching process 1^{st} etch in which a portion of the plurality of semiconductor material layers SEM1L, SEM2L, MQWL, and SEM3L and the element electrode material layer ELTL is etched using the plurality of first mask patterns MP1 as a mask is performed.

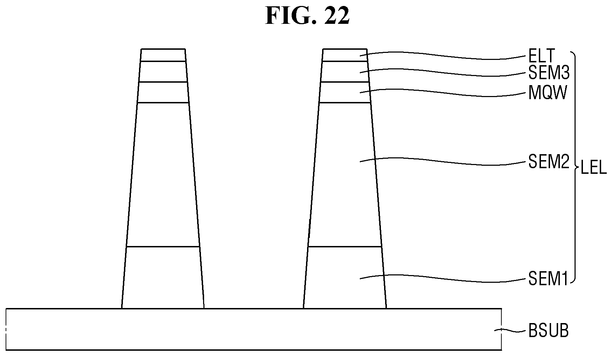

As shown in FIG. 22, on the base substrate BSUB, the plurality of semiconductor material layers SEM1L, MQWL, SEM2L, and SEM3L and the element electrode material layer ELTL that are non-overlapping with the first mask pattern MP1 are etched and removed, and the unetched portion overlapping with the first mask pattern MP1 may be formed as an element rod LEL.

The plurality of semiconductor material layers may be etched by conventional methods. For example, the process of etching the plurality of semiconductor material layers may be performed by dry etching, wet etching, reactive ion etching (RIE), deep reactive ion etching (DRIE), inductively coupled plasma reactive ion etching (ICP-RIE), and the like. In the case of dry etching methods, anisotropic etching is possible, which may be suitable for vertical etching. When utilizing the etching method described above, the etchant may be Cl₂ or O₂. However, the present disclosure is not limited thereto.

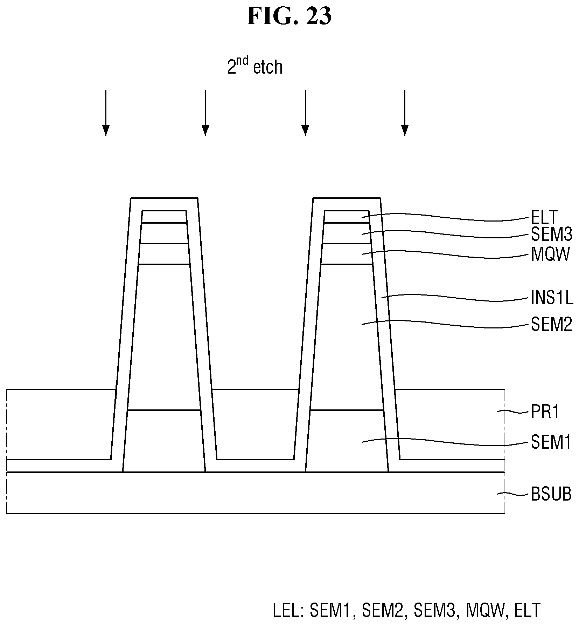

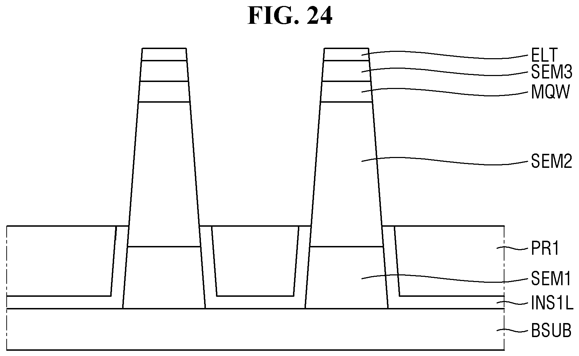

Next, referring to FIGS. 23 and 24, a first insulating material layer INS1L is formed on the base substrate BSUB. The first insulating material layer INS1L may be formed on the entire surface of the base substrate BSUB to cover the element rod LEL. The first insulating material layer INS1L is formed entirely on the outer surface of the first semiconductor layer SEM1, the second semiconductor layer SEM2, the light emitting layer MQW, the first semiconductor layer SEM1, and the element electrode layer ELT of the element rod LEL.

Then, a first photoresist PR1 is formed on the base substrate BSUB. The first photoresist PR1 may be formed on the first insulating material layer INS1L to a predetermined height of the element rod LEL. For example, the first photoresist PR1 may be formed to be greater than or equal to the height of the first semiconductor layer SEM1 and may be formed to a partial height of the second semiconductor layer SEM2.

Next, a second etching process 2^{nd} etch is performed to partially remove the first insulating material layer INS1L. Specifically, the first insulating material layer INS1L exposed above the first photoresist PR1 may be removed by etching. In the present process, the first insulating material layer INS1L may be removed so that a portion of the second semiconductor layer SEM2, the light emitting layer MQW, the first semiconductor layer SEM1, and the element electrode layer ELT of the element rod LEL are exposed. Accordingly, the first insulating material layer INS1L may be formed to surround the outer surface of the first semiconductor layer SEM1 of the element rod LEL and a portion of the outer surface of the second semiconductor layer SEM2. After the etching process of the first insulating material layer INS1L is completed, the first photoresist PR1 may be removed.

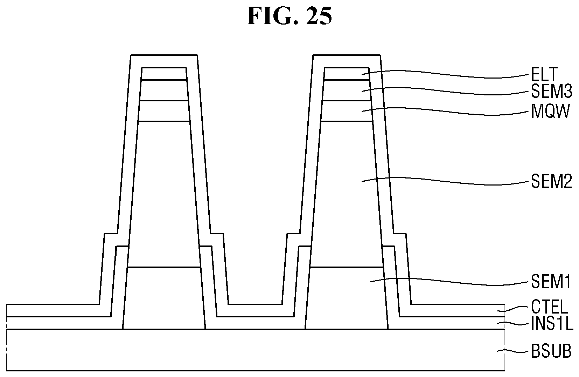

Next, referring to FIG. 25, a contact electrode material layer CTEL is stacked on the base substrate BSUB. The contact electrode material layer CTEL may be formed on the entire surface of the base substrate BSUB to cover the element rod LEL. The contact electrode material layer CTEL is formed entirely on the outer surfaces of the second semiconductor layer SEM2, the light emitting layer MQW, the first semiconductor layer SEM1, and the element electrode layer ELT of the element rod LEL. In addition, the contact electrode material layer CTEL is also formed on the outer and top surfaces of the first insulating material layer INS1L.

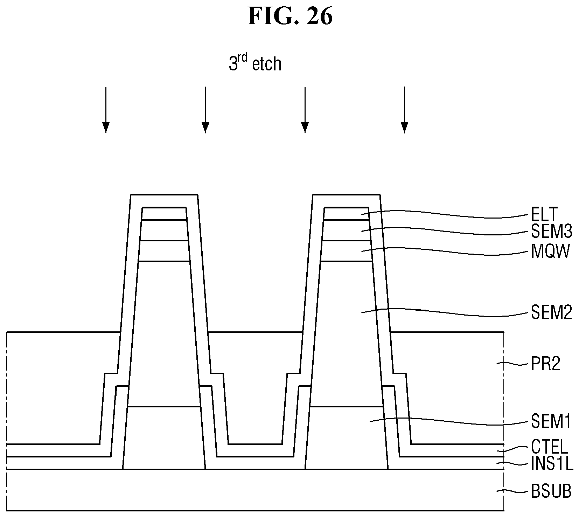

Next, referring to FIG. 26, a second photoresist PR2 is formed on the base substrate BSUB. The second photoresist PR2 may be formed on the contact electrode material layer CTEL to a predetermined height of the element rod LEL. For example, the second photoresist PR2 may be formed at least higher than the height of the first insulating material layer INS1L and may be formed up to a partial height of the second semiconductor layer SEM2.

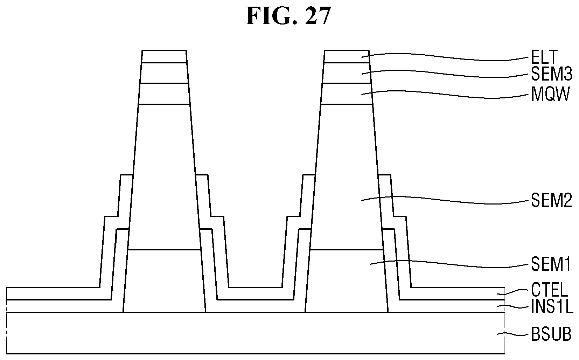

Next, referring to FIG. 27 in conjunction with FIG. 26, a third etching process 3^{rd} etch is performed to partially remove the contact electrode material layer CTEL. Specifically, the contact electrode material layer CTEL exposed above the second photoresist PR2 may be removed by etching. In the present process, the contact electrode material layer CTEL may be removed so that a portion of the second semiconductor layer SEM2, the light emitting layer MQW, the first semiconductor layer SEM1, and the element electrode layer ELT of the element rod LEL are exposed. Accordingly, the contact electrode material layer CTEL may be formed to surround the outer surface of the first insulating material layer INS1L and a portion of the outer surface of the second semiconductor layer SEM2 of the element rod LEL. After the etching process of the contact electrode material layer CTEL is completed, the second photoresist PR2 may be removed.

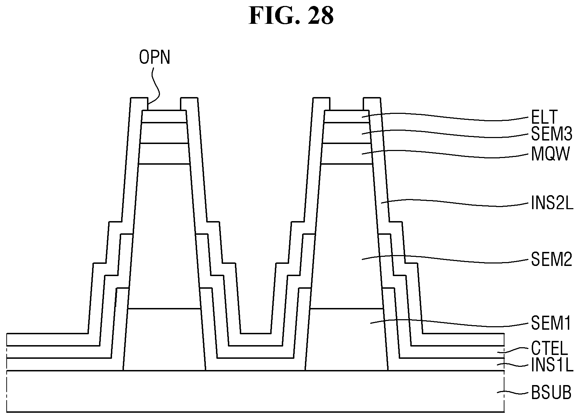

Next, referring to FIG. 28, a portion of a second insulating material layer INS2L is etched to form an opening OPN. The opening OPN may expose the top of the element rod LEL. The element electrode layer ELT may be disposed at the top of the element rod LEL, and a portion of the top surface of the element electrode layer ELT may be exposed through the opening OPN of the second insulating material layer INS2L.

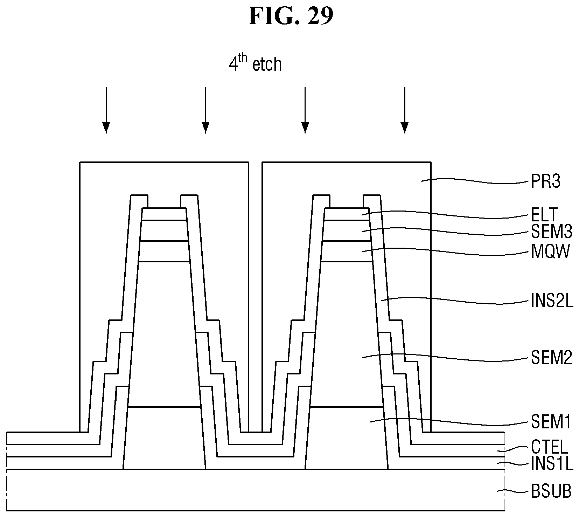

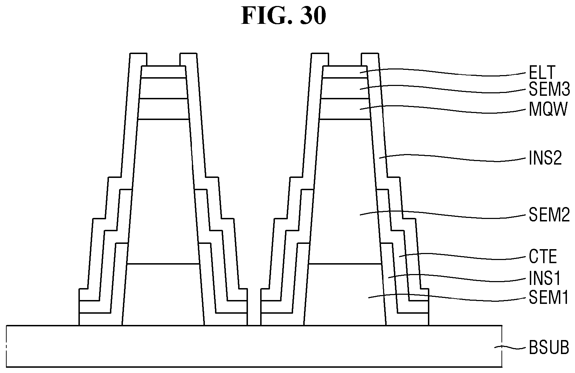

Then, referring to FIGS. 29 and 30, a third photoresist PR3 is formed on the base substrate BSUB. The third photoresist PR3 may be patterned to cover each element rod LEL. The third photoresist PR3 may be formed to cover the second insulating material layer INS2L by including the element rod LEL. The third photoresist PR3 may be patterned in an island pattern shape to cover each element rod LEL and be spaced apart from each other.

Subsequently, a fourth etching process 4^{th} etch is performed to etch the first insulating material layer INS1L, the contact electrode material layer CTEL, and the second insulating material layer INS2L. The first insulating material layer INS1L, contact electrode material layer CTEL, and second insulating material layer INS2L exposed by the third photoresist PR3 may be etched and removed. Accordingly, a plurality of element rods LEL including the first semiconductor layer SEM1, the second semiconductor layer SEM2, the light emitting layer MQW, the third semiconductor layer SEM3, the element electrode layer ELT, the first insulating layer INS1, the contact electrode CTE, and the second insulating layer INS2 are formed. The plurality of element rods LEL may be disposed to be spaced apart from each other on the base substrate BSUB.

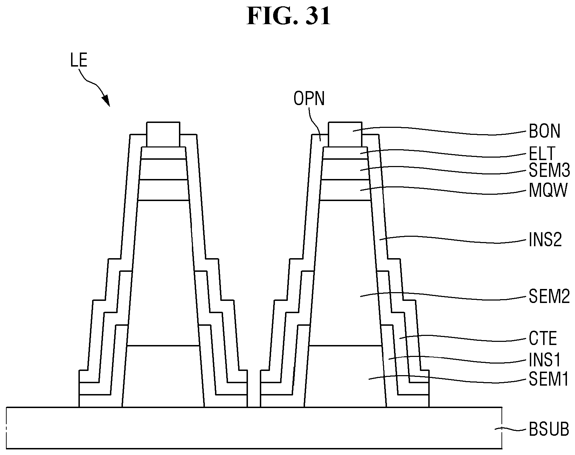

Next, referring to FIG. 31, a connection electrode BON is formed on the element rod LEL. The connection electrode BON may be formed through a patterning process after stacking a connection electrode material layer. The connection electrode BON may be formed in the opening OPN of the second insulating layer INS2. The connection electrode BON may be directly disposed on the element electrode layer ELT of the element rod LEL and may be formed to protrude above the second insulating layer INS2. As a result, the light emitting element LE including the element rod LEL and the connection electrode BON is manufactured.

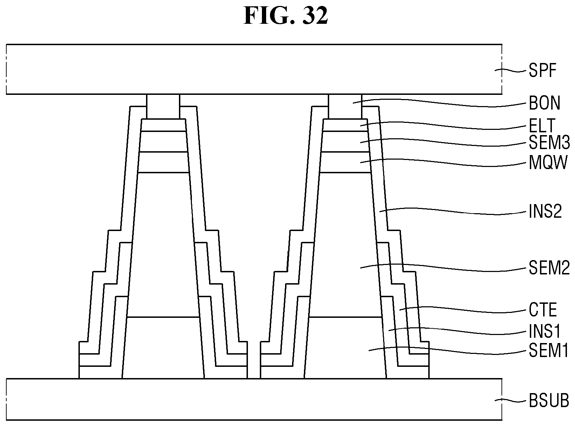

Next, referring to FIG. 32, a support film SPF is attached to the plurality of light emitting elements LE of the base substrate BSUB manufactured in FIG. 31.

Specifically, the support film SPF is attached on the plurality of light emitting elements LE. The support film SPF may be aligned on the plurality of light emitting elements LE and attached to each connection electrode BON of the plurality of light emitting elements LE. The plurality of light emitting elements LE are arranged in large numbers and may be attached without being detached from the support film SPF.

The support film SPF may include a support layer and an adhesive layer disposed on the support layer. The support layer may be made of a material that is transparent and has mechanical stability to allow light to pass therethrough. For example, the support layer may include a transparent polymer such as polyester, polyacrylic, polyepoxy, polyethylene, polystyrene, polyethylene terephthalate, etc. The adhesive layer may include an adhesive material for bonding the light emitting elements LE. For example, the adhesive material may include urethane acrylate, epoxy acrylate, polyester acrylate, etc. The adhesive material may be a material whose adhesive strength changes as ultraviolet (UV) light or heat is applied, and thus the adhesive layer can be easily separated from the light emitting elements LE.

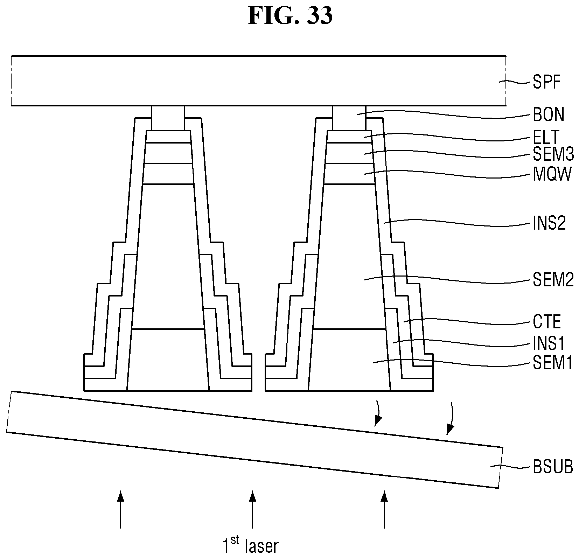

Subsequently, referring to FIG. 33, the base substrate BSUB and the light emitting element LE are separated by irradiating the base substrate BSUB with a laser (1^{st} laser). The base substrate BSUB is separated from the first semiconductor layer SEM1 and the first insulating layer INS1 of the plurality of light emitting elements LE.

The process of separating the base substrate BSUB and the light emitting element LE may be done using a laser lift off (LLO) process. The laser lift-off process uses a laser, and a KrF excimer laser (248 nm wavelength) may be used as the source. The energy density of the excimer laser is irradiated in the range of about 550 mJ/cm² to 950 mJ/cm², and the incident area may be in the range of 50 x 50 µm² to 1 x 1 cm² but is not limited thereto.

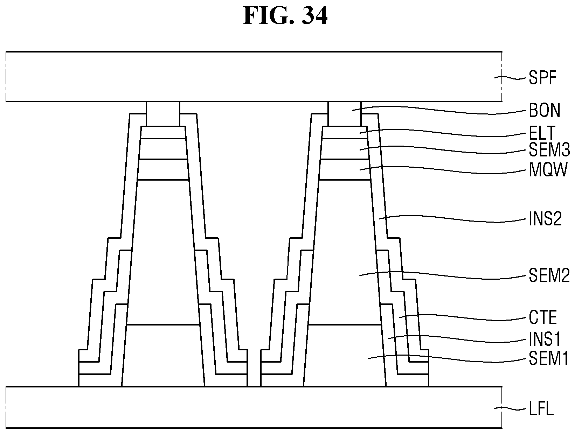

Next, referring to FIG. 34, a transfer film LFL is attached to the plurality of light emitting elements LE.

Specifically, the transfer film LFL is attached on the first semiconductor layer SEM1 and the first insulating layer INS1 of each of the plurality of light emitting elements LE. The transfer film LFL may be aligned on the plurality of light emitting elements LE and attached to the lower surface of the first semiconductor layer SEM1 and the first insulating layer INS1 of each of the plurality of light emitting elements LE.

The transfer film LFL may include a stretchable material. The stretchable material may include, for example, polyolefin, polyvinyl chloride (PVC), elastomeric silicone, elastomeric polyurethane, elastomeric polyisoprene, and the like. Since the transfer film LFL includes the support layer and the adhesive layer like the support film SPF, the plurality of light emitting elements LE may be adhered and supported.

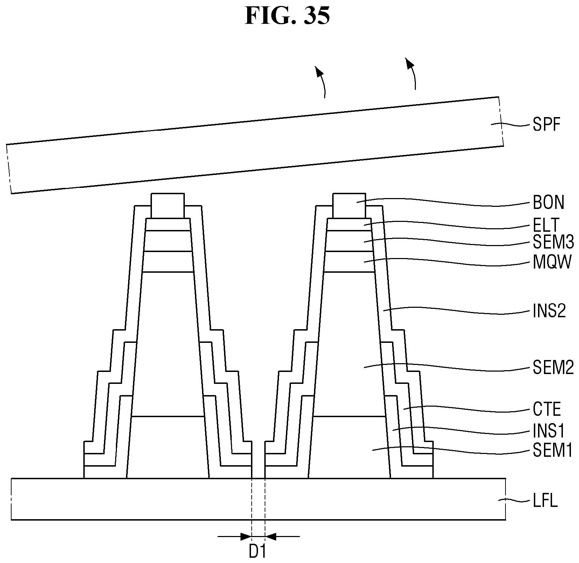

Subsequently, referring to FIG. 35, the support film SPF is separated from the plurality of light emitting elements LE. After reducing the adhesive strength of the adhesive layer of the support film SPF by applying ultraviolet rays or heat to the support film SPF, the support film SPF may be physically or naturally separated. The plurality of light emitting elements LE may be arranged in a dot shape on the transfer film LFL, spaced apart from each other at a predetermined first interval D1.

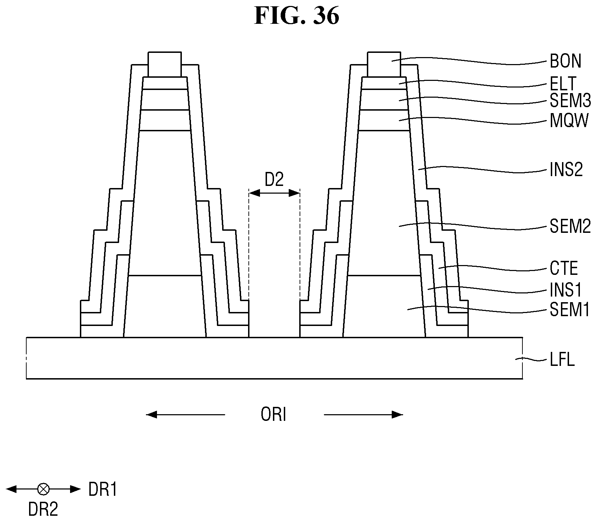

Next, referring to FIG. 36, the transfer film LFL is stretched (ORI). The transfer film LFL may be stretched two-dimensionally including the first direction DR1 and the second direction DR2. As the transfer film LFL is stretched, the spacing between the plurality of light emitting elements LE bonded on the transfer film LFL may become a second interval D2, which is increased than the first interval D1 of FIG. 35. The stretching strength (or tensile strength) of the transfer film LFL may be adjusted depending on the desired spacing between the light emitting elements LE, and may be, for example, about 120 gf/inch. However, the present disclosure is not limited to thereto. In the present embodiment, performing stretching process once is exemplified, but the present disclosure is not limited thereto. The stretching process may be performed multiple times.

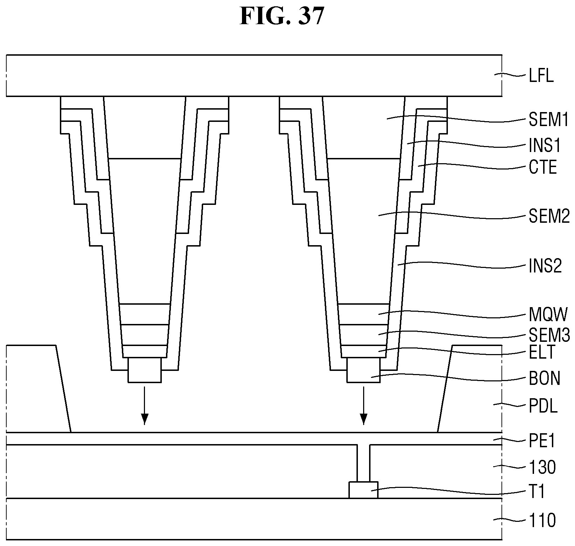

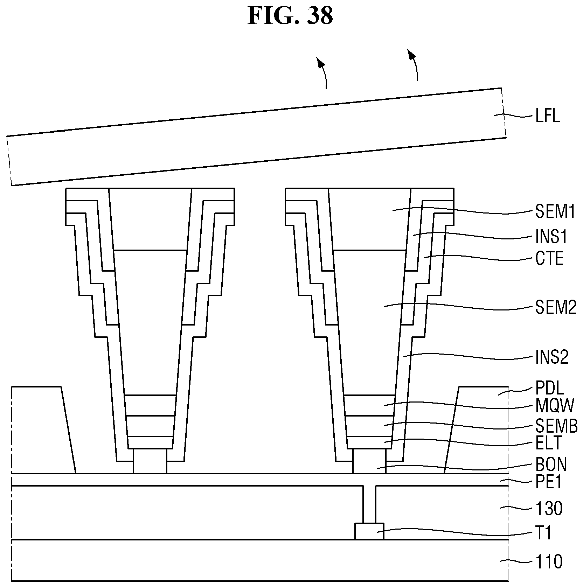

Next, referring to FIGS. 37 and 38, the transfer film LFL is bonded to a substrate 110 and the plurality of light emitting elements LE are bonded to first pixel electrodes PE1.

Specifically, the transfer film LFL is aligned on the substrate 110. At this time, the connection electrode BON of the light emitting element LE formed on the transfer film LFL is aligned to face the substrate 110. As shown in FIG. 6, the substrate 110 may be formed of a plurality of pixel electrodes PE1 and a pixel defining layer PDL.

Subsequently, the substrate 110 and the transfer film LFL are bonded. Specifically, the connection electrode BON of the light emitting element LE formed on the transfer film LFL is brought into contact with the first pixel electrodes PE1 of the substrate 110. At this time, the connection electrode BON of the light emitting element LE is in contact with the first pixel electrode PE1. Then, the substrate 110 and the transfer film LFL are bonded to each other by melting the connection electrodes BON of the light emitting elements LE and the first pixel electrodes PE1. At this time, the plurality of light emitting elements LE are attached to the top surfaces of the first pixel electrodes PE1.

As for a melt bonding, a laser may be irradiated onto the pixel electrodes PE1 from the top of the transfer film LFL. The laser-irradiated pixel electrodes PE1 may conduct high heat from the laser to bond the interface of the connection electrode BON of the light emitting element LE and the pixel electrodes PE1. In particular, the pixel electrodes PE1 may include copper (Cu), which has excellent thermal conductivity, and may have excellent adhesion properties with the connection electrode BON of the light emitting element LE. As a source of the laser used for the melt bonding, a YAG may be utilized.

Subsequently, the transfer film LFL is separated from the plurality of light emitting elements LE.

Specifically, the transfer film LFL is separated from the first semiconductor layer SEM1 of the light emitting element LE. The process of separating the transfer film LFL may be a laser lift off (LLO) process. In the laser lift off process using laser, KrF excimer laser (248 nm wavelength) may be used as a source. The energy density of the excimer laser is irradiated in the range of about 550 mJ/cm² to 950 mJ/cm², and the incident area may be in the range of 50 x 50 µm² to 1 x 1 cm², but the present disclosure is not limited thereto. By irradiating the laser to the transfer film LFL, the transfer film LFL may be separated from the light emitting element LE.

In another example, the process of separating the transfer film LFL may be physically separated in addition to the laser lift-off process. Since the bonding strength between the transfer film LFL and the light emitting element LE is smaller than the bonding strength between the connection electrode BON and the light emitting element LE and the pixel electrodes PE1 that are melt-bonded, the transfer film LFL may be physically separated based on the difference in bonding strength.

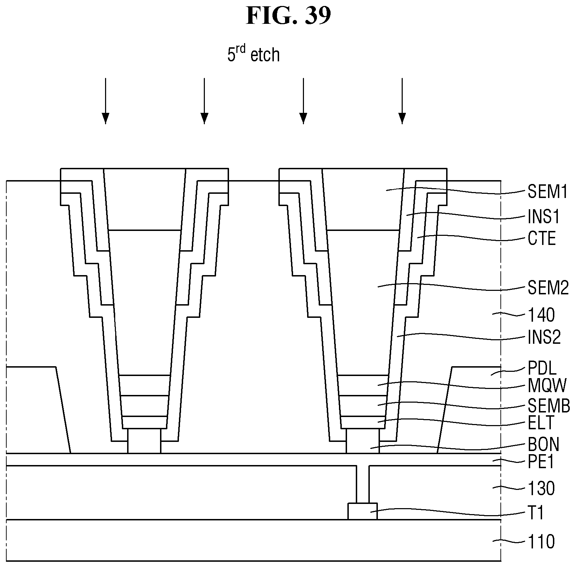

Next, referring to FIG. 39, an organic layer 140 is formed on the substrate 110 on which the light emitting elements LE are formed. The organic layer 140 may be formed on the first pixel electrodes PE1 and the pixel defining layer PDL. The organic layer 140 may be disposed on each emission area and spaced apart from each other between adjacent emission areas. The organic layer 140 may be formed by being coated using a solution process such as spin coating or inkjet printing and then patterned through an exposure process. The organic layer 140 may be formed to have a height equal to or smaller than that of the first semiconductor layer SEM1 of the light emitting element LE but is not limited thereto.

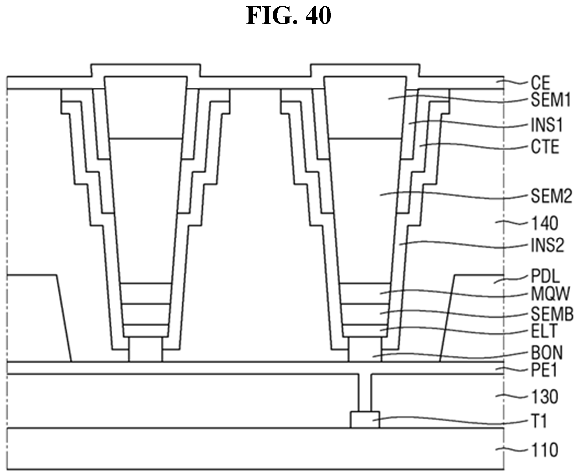

Next, referring to FIGS. 39 and 40 together, a fifth etching process 5^{th} etch is performed to etch a portion of the first insulating layer INS1 of each light emitting element LE. In the fifth etching process, a top portion of the first insulating layer INS1 may be etched and removed. For example, a portion of the first insulating layer INS1 that covers the top surface of the contact electrode CTE may be etched and removed.

As shown in FIG. 40, the first insulating layer INS1 is etched to be aligned with the top surface of the contact electrode CTE, so that the top surface of the first insulating layer INS1 and the top surface of the contact electrode CTE are formed to be aligned with each other. The top surface of the contact electrode CTE may be exposed upwardly by etching the first insulating layer INS1.

Next, a common electrode CE is formed on the light emitting element LE and the organic layer 140. The common electrode CE is continuously formed throughout the display area. The common electrode CE covers the organic layer 140 and the light emitting element LE and is in direct contact with them. For example, the common electrode CE may be in contact with the first semiconductor layer SEM1, the first insulating layer INS1, and the contact electrode CTE of the light emitting element LE. Since the common electrode CE is in contact with the contact electrode CTE, the low potential voltage applied from the common electrode CE may be transmitted to the light emitting element LE through the contact electrode CTE.

Thereafter, as shown in FIG. 6, the display device 10 according to one embodiment is manufactured by forming a wavelength control layer, a color filter layer, and the like.

The manufacturing method of the display device 10 according to one embodiment can electrically connect the common electrode CE and the light emitting element LE while omitting the removal process of the first semiconductor layer SEM1. Therefore, the manufacturing process of the display device 10 can be simplified and process defects can be prevented.

Although the embodiments of the present invention have been described above with reference to the accompanying drawings, it will be understood by those of ordinary skill in the art to which the present invention pertains that the present invention may be embodied in other specific forms without changing the technical spirit or essential characteristics of the present invention. Therefore, the embodiments described above are to be understood as illustrative in all respects and not restrictive.

## Claims

1. A light emitting element comprising:
a first semiconductor layer;
a second semiconductor layer disposed on the first semiconductor layer;
a light emitting layer disposed on the second semiconductor layer;
a third semiconductor layer disposed on the light emitting layer;
an element electrode layer disposed on the third semiconductor layer;
a connection electrode disposed on the element electrode layer;
a first insulating layer surrounding the side surfaces of the first semiconductor layer and the second semiconductor layer;
a contact electrode surrounding the side surfaces of the first insulating layer and the second semiconductor layer; and
a second insulating layer surrounding the side surfaces of the second semiconductor layer, the light emitting layer, the third semiconductor layer, the element electrode layer, and the connection electrode,
wherein the contact electrode is in contact with the side surface of the second semiconductor layer.

2. The light emitting element of claim 1,
wherein the first insulating layer surrounds the entire side surface of the first semiconductor layer and a portion of the side surface of the second semiconductor layer.

3. The light emitting element of claim 1,
wherein the contact electrode is not in contact with the first semiconductor layer.

4. The light emitting element of claim 1,
wherein the second insulating layer surrounds the side surface of the contact electrode but is not in contact with the first insulating layer.

5. The light emitting element of claim 1, further comprising:
a contact area in which the contact electrode and the second semiconductor layer are in contact with each other,
wherein the contact area is disposed in an area ranging from 1 to 90% of the length of the second semiconductor layer from the interface between the first semiconductor layer and the second semiconductor layer.

6. The light emitting element of claim 5,
wherein the contact area ranges from 1 to 90% of the total area of the side surface of the second semiconductor layer.

7. The light emitting element of claim 1,
wherein the side surface of the first insulating layer, the side surface of the contact electrode, and the side surface of the second insulating layer are aligned with each other.

8. The light emitting element of claim 1,
wherein the first insulating layer is not in contact with the second semiconductor layer.

9. The light emitting element of claim 1,
wherein the second insulating layer is not in contact with the side surface of the contact electrode and is aligned with the side surface of the contact electrode.

10. The light emitting element of claim 1, further comprising:
a reflective layer surrounding the side surface of the second insulating layer,
wherein the side surface of the reflective layer is aligned with the side surface of the contact electrode.

11. The light emitting element of claim 1,
wherein the first semiconductor layer includes undoped semiconductor, the second semiconductor layer includes an n-type semiconductor, and the third semiconductor layer includes a p-type semiconductor.

12. A display device comprising:
a substrate;
a pixel electrode disposed on the substrate;
light emitting elements disposed on the pixel electrode;
a first organic layer disposed on the pixel electrode and disposed between the light emitting elements; and
a common electrode disposed on the first organic layer and the light emitting elements,
wherein each of the light emitting elements comprises:
a connection electrode disposed on the pixel electrode;
an element electrode layer disposed on the connection electrode;
a third semiconductor layer disposed on the element electrode layer;
a light emitting layer disposed on the third semiconductor layer;
a second semiconductor layer disposed on the light emitting layer;
a first semiconductor layer disposed on the second semiconductor layer;
a first insulating layer surrounding the side surfaces of the first semiconductor layer and the second semiconductor layer;
a contact electrode surrounding the side surfaces of the first insulating layer and the second semiconductor layer; and
a second insulating layer surrounding the side surfaces of the second semiconductor layer, the light emitting layer, the third semiconductor layer, the element electrode layer, and the connection electrode,
wherein the contact electrode is disposed on the side surface of the second semiconductor layer and the common electrode is connected to the contact electrode.

13. The display device of claim 12,
wherein the connection electrode is connected to the pixel electrode and the second semiconductor layer is electrically connected to the common electrode through the connection electrode.

14. The display device of claim 12,
wherein the top surface of the first organic layer is aligned with the top surface of the first insulating layer and the top surface of the contact electrode.

15. The display device of claim 12,
wherein the common electrode is disposed on the first semiconductor layer, the first insulating layer, the contact electrode, and the first organic layer.

16. The display device of claim 12, further comprising:
a third insulating layer disposed between the first semiconductor layer and the common electrode, and
the common electrode is not in contact with the first semiconductor layer.

17. The display device of claim 16,
wherein the third insulating layer is in contact with the first semiconductor layer and is not in contact with the first insulating layer.

18. The display device of claim 12,
wherein the common electrode is in contact with the side surface of the first insulating layer and the side surface of the contact electrode.

19. The display device of claim 12,
wherein the light emitting element further comprises a reflective layer surrounding the side surface of the second insulating layer, and the first organic layer covers the reflective layer.

20. The display device of claim 12, further comprising:
a second organic layer disposed on the first organic layer,
wherein the common electrode is disposed between the first organic layer and the second organic layer.

21. The display device of claim 20,
wherein the common electrode surrounds and is in contact with the side surface of the contact electrode, and the second organic layer covers a portion of the common electrode.

22. A method of manufacturing a display device, the method comprising:
forming a pixel electrode on a substrate;
forming light emitting elements on a base substrate;
combining the light emitting elements formed on the base substrate on the pixel electrode;
forming an organic layer between the light emitting elements on the pixel electrode; and
forming a common electrode on the organic layer and the light emitting elements,
wherein the forming the light emitting elements on the base substrate comprises:
forming a first semiconductor layer, a second semiconductor layer, a light emitting layer, a third semiconductor layer, and an element electrode layer on the base substrate;
forming a first insulating layer surrounding the side surfaces of the first semiconductor layer and the second semiconductor layer;
forming a contact electrode surrounding the side surfaces of the first insulating layer and the second semiconductor layer;
forming a second insulating layer surrounding the side surfaces of the second semiconductor layer, the light emitting layer, the third semiconductor layer, and the element electrode layer; and
forming a connection electrode on the element electrode layer.

23. The method of claim 22,
wherein the first insulating layer, the second insulating layer, and the contact electrode is formed by simultaneously etching a first insulating material layer, a contact electrode material layer, and a second insulating material layer.

24. The method of claim 22,
wherein the combining the light emitting elements formed on the base substrate on the pixel electrode comprises:
bonding a support film on connection electrodes of the light emitting elements;
separating the base substrate from the light emitting elements;
bonding a transfer film on one surface of the light emitting elements facing the support film;
separating the support film from the light emitting elements;
combining the connection electrodes of the light emitting elements on the pixel electrode; and
removing the transfer film from the light emitting elements.

25. The method of claim 24,
wherein, after the separating the support film from the light emitting elements, the transfer film is stretched to increase the interval between the light emitting elements.

26. The method of claim 24,
wherein, in the combining the connection electrodes of the light emitting elements on the pixel electrode, a laser is irradiated on to the pixel electrode to melt bond the connection electrode to the pixel electrode.
